# EUROPEAN PATENT APPLICATION

(11) **EP 4 401 158 A1**
(43) Date of publication of application: **17.07.2024**
(21) Application number: 22867450.3
(22) Date of filing: 09.09.2022
(51) Int. Cl.: H01L 33/16, C30B 29/38, H01L 21/205, H01L 33/32

(54) **GROUP III NITRIDE LIGHT-EMITTING DEVICE, GROUP III NITRIDE EPITAXIAL WAFER, AND METHOD FOR PRODUCING GROUP III NITRIDE LIGHT-EMITTING DEVICE**

(30) Priority: 09.09.2021 JP 2021147191
(71) Applicant: Mie University, Tsu-shi, Mie 514-8507 (JP)
(72) Inventor: UESUGI, Kenjiro, Tsu-shi, Mie 514-8507 (JP); MIYAKE, Hideto, Tsu-shi, Mie 514-8507 (JP); NAKAMURA, Takao, Tsu-shi, Mie 514-8507 (JP)
(74) Representative: Bergenstråhle & Partners AB
(86) International application number: PCT/JP2022/033975
(87) International publication number: WO 2023/038129

(57) **Abstract**

A III nitride light-emitting device comprises: a template member having a template layer that includes compressive strain and covers the principal surface including AlxGai-xN that has a full width at half maximum of a (10-12)-face X-ray rocking curve with 1000 arcsec or lower, where X is greater than zero and 1 or less; an active layer including a compressively strained AlGaN and generating light having a peak wavelength in deep ultraviolet wavelengths of 285 nm or below; and an n-type III nitride semiconductor region disposed on the template member. The n-type III nitride semiconductor region has an n-type first and second III nitride semiconductor layers on the template member. The n-type first III nitride semiconductor layer has a lattice relaxation rate of 2% or less relative to that of the template layer, and the n-type second III nitride semiconductor layer has a surface roughness of 0.4 nm or less.

## Description

### Technical Field

The present invention relates to a III nitride light-emitting device, a III nitride epitaxial wafer, and a method for fabricating a III nitride light-emitting device.

### Background Art

Patent Document 1 discloses a template structure.

Patent Document 2 discloses a nitride semiconductor ultraviolet light-emitting device. The nitride semiconductor ultraviolet light-emitting device includes an n-type cladding layer of an n-type AlGaN-based semiconductor layer, an active layer, a p-type cladding layer, and an n-type contact layer. The active layer has an AlGaN-based semiconductor layer having a bandgap energy of 3.4 eV or below.

Patent Document 3 discloses a nitride semiconductor light-emitting device. The nitride semiconductor light-emitting device includes a semiconductor stack comprising an n-type laminate, an active layer, and a p-type laminate. On the n-contact layer, an intermediate layer is disposed. The n-type laminate includes an n-contact layer made of an AlxGa1-xN (0.7 ≤ x ≤ 1.0), and an n-cladding layer disposed on the n-contact layer.

Patent Document 4 discloses a semiconductor light-emitting device. The semiconductor light-emitting device includes an n-type first cladding layer, an n-type second cladding layer, an active layer, and a p-type semiconductor layer. The n-type first cladding layer is made of an n-type AlGaN-based semiconductor disposed on an aluminum nitride (AlN) layer. The n-type second cladding layer is disposed on the n-type first cladding layer, and made of n-type AlGaN-based semiconductor that has an AlN mole fraction of 50% or less , which is lower than that of the n-type first cladding layer.

Patent Document 5 discloses a semiconductor light emitting device. The semiconductor light-emitting device includes an n-type cladding layer, a planarization layer, an active layer, and a p-type semiconductor layer. The n-type cladding layer is made of n-type AlGaN-based semiconductor material having an AlN mole fraction of 20% or more. The planarization layer is made of AlGaN-based semiconductor material disposed on the n-type cladding layer.

### Prior Art Document

### Patent Document

Patent Document 1: Japanese Patent application Laid-Open No. 2017-55116
Patent Document 2: Japanese Patent application Laid-Open No. 2012-89754
Patent Document 3: Japanese Patent application Laid-Open No. 2010-161311
Patent Document 4: Japanese Patent application Laid-Open No. 2018-156970
Patent Document 5: Japanese Patent application Laid-Open No. 2019-33284

### SUMMARY OF INVENTION

### Technical Problem

In blue and longer wavelengths, a III nitride light-emitting semiconductor device has an active layer including GaN (gallium nitride) barrier layers and InGaN well layers, and is fabricated on a GaN substrate or a GaN template layer on a sapphire substrate. In contrast, in UV-wavelengths, a semiconductor light-emitting device has an active layer including, for example, AlGaN barriers and AlGaN wells, which are fabricated on a bulk AlN substrate or an AlN (aluminum nitride) template layer on a sapphire substrate.

Considering, for example, blue semiconductor lasers in light of electrical characteristics, the n-type semiconductor is provided with low resistance due to silicon-doped GaN, while the p-type semiconductor is provided with a higher electrical resistance, which is caused by magnesium dopant and AlGaN, than that of the n-type semiconductor.

Considering, ultraviolet, particularly, deep ultraviolet light-emitting semiconductor devices in light of electrical characteristics, in the p-type semiconductors, AlGaN of a larger Al molar fraction than that of AlGaN of blue semiconductor lasers are doped with magnesium, and in the n-type semiconductors, silicon is still used as a dopant. However, using an AlN template layer as underlying semiconductor needs to change the material of the n-type semiconductor layers from GaN to AlN or AlGaN of higher Al molar fractions.

Comparing blue light-emitting devices and UV light-emitting devices with each other in light of n-type semiconductors, blue-light emitting devices, particularly semiconductor lasers, have an Al molar fraction profile which is increased in the direction from the GaN semiconductor base to the active layer in order to obtain carrier confinement, while ultraviolet light-emitting devices, such as deep UV light-emitting diodes, have an Al molar fraction profile which is reduced in the direction from the AlN semiconductor base to the active layer in order to obtain an Al molar fraction that allows the active layer to emit light of deep UV wavelengths.

As seen from the above description, the deep UV light-emitting semiconductor devices have been developed in material environments different from those of the blue light-emitting devices of longer wavelengths.

Patent Document 1 discloses a template with an excellent quality. The excellent-quality template of Patent Document 1 provides a principal surface of a large Al molar fraction material, for example, an AlN. In deep ultraviolet wavelengths, particularly the vicinity of 285nm and shorter wavelengths, the emission power of the III nitride light-emitting device becomes lower. The active layer that would be compressively strained may increase the emission intensity in the deep ultraviolet wavelengths. Any of Patent Documents 2 to 5 do not disclose active layers with compressive strain.

It is an object of some aspects of the present invention to provide a III nitride light-emitting device that includes a compressively-strained active layer, the method of making the same, and a III nitride epitaxial wafer therefor.

### Solution to Problem

In order to achieve the above object, the first aspect of the present invention includes a III nitride light-emitting device, which comprises: a template member including a support having a principal surface and a template layer covering the principal surface of the support, the principal surface being made of material different from III nitride, the template layer including compressive strain, the template layer including an Al_{X}Ga_{1-X}N, and the AlxGai-xN having a full width at half maximum of a (10-12)-face X-ray rocking curve of 1000 arcsec or lower, where X is greater than zero and equal to or less than 1; an active layer disposed on the template member so as to generate light having a peak wavelength in deep ultraviolet wavelengths 285 nm or below, the active layer including a compressively strained AlGaN, and an n-type III nitride semiconductor region disposed between the template member and the active layer, the n-type III nitride semiconductor region containing Al as a III constituent element, the n-type III nitride semiconductor region including: an n-type first III nitride semiconductor layer disposed between the template layer and the active layer; and an n-type second III nitride semiconductor layer disposed between the n-type first III nitride semiconductor layer and the active layer, the n-type first III nitride semiconductor layer including a lattice relaxation rate of 2% or less relative to that of the template layer, and the n-type second III nitride semiconductor layer having a surface roughness of 0.4 nm or less.

The second aspect of the present invention includes a III nitride epitaxial wafer, which comprises: a template substrate having a principal surface made of material different from III nitride, a template layer including AlxGai-xN that has a full width at half maximum of a (10-12)-face X-ray rocking curve of 1000 arcsec or less, where X is greater than zero and not more than 1, and the template layer covering the principal surface of the substrate and including compressive strain; an active layer disposed on the template substrate so as to generate light having a peak wavelength in deep ultraviolet wavelengths of 285 nm or below, the active layer including an AlGaN, and the AlGaN incorporating compressive strain; and an n-type III nitride semiconductor region disposed between the template substrate and the active layer, and including Al as a III constituent element, the n-type III nitride semiconductor region including an n-type first III nitride semiconductor layer disposed between the template layer and the active layer, and an n-type second III nitride semiconductor layer disposed between the n-type first III nitride semiconductor layer and the active layer, the n-type first III nitride semiconductor layer having a lattice relaxation rate of 2% or less relative to the template layer, and the n-type second III nitride semiconductor layer having a surface roughness of 0.4 nm or less.

The third aspect of the present invention includes a method of making a III nitride light-emitting device, which comprises: preparing a template that includes a substrate having a principal surface of material different from III nitride, and a template layer that covers the principal surface of the substrate and includes AlxGai-xN having a full width at half maximum of a (10-12)-face X-ray rocking curve of 1000 arcsec, where X is greater than zero and less than or equal to 1; and growing, on the template layer, a III nitride semiconductor region, the III nitride semiconductor region having an n-type first III nitride semiconductor layer doped with an n-type dopant, and an n-type second III nitride semiconductor layer doped with an n-type dopant, and an active layer including AlGaN and having a peak wavelength in deep ultraviolet wavelengths of 285 nm or below, the n-type first III nitride semiconductor layer being disposed between the template layer and the active layer, the n-type second III nitride semiconductor layer being disposed between the n-type III nitride semiconductor layer and the active layer, growing, on the template layer, a III nitride semiconductor region including growing the n-type first III nitride semiconductor layer and the n-type second III nitride semiconductor layer using at least one of first to third conditions as follows: the first condition in which a growth temperature of the n-type first III nitride semiconductor layer is greater than that of the n-type second III nitride semiconductor layer; the second condition in which a growth rate of the n-type first III nitride semiconductor layer is greater than that of the n-type second III nitride semiconductor layer; and the third condition in which an NH₃ partial pressure of the n-type first III nitride semiconductor layer is greater than that of the n-type second III nitride semiconductor layer.

### Advantageous Effects of Invention

The first aspect can provide a III nitride light-emitting device that includes a compressively-strained active layer. The second aspect can provide a III nitride epitaxial wafer for a III nitride light-emitting device that includes a compressively-strained active layer. The third aspect can provide the method of making a III nitride light-emitting device that includes a compressively-strained active layer.

### BRIEF DESCRIPTION OF DRAWINGS

FIG. 1 is a schematic view illustrating a III nitride light-emitting device (hereinafter referred to as a "light-emitting device") according to an embodiment of the invention.
FIG. 2 is a view illustrating the light-emitting device according to the embodiment of the invention.
FIG. 3 is a schematic view illustrating a III nitride epitaxial wafer according to an embodiment of the invention.
FIG. 4A is a view illustrating a major step in the method of making a light-emitting device according to an embodiment of the invention.
FIG. 4B is a view illustrating a major step in the method of making a light-emitting device according to the embodiment of the invention.
FIG. 5A is a view illustrating a major step in the method of making a light-emitting device according to the embodiment of the invention.
FIG. 5B is a view illustrating a major step in the method of making a light-emitting device according to the embodiment of the invention.
FIG. 6A is a view illustrating a major step in the method of making a light-emitting device according to the embodiment of the invention.
FIG. 6B is a view illustrating a major step in the method of making a light-emitting device according to the embodiment of the invention.
FIG. 7A is a view illustrating a major step in the method of making a light-emitting device according to the embodiment of the invention.
FIG. 7B is a view illustrating a major step in the method of making a light-emitting device according to the embodiment of the invention.
FIG. 8A is a schematic view showing a laminate structure of a nitride semiconductor substrate according to the embodiment.
FIG. 8B is a schematic view illustrating a laminate structure of a light-emitting diode according to the embodiment.
FIG. 9 is a flowchart showing major steps in the method of manufacturing a light-emitting device and the method of manufacturing an epitaxial wafer according to the embodiment.
FIG. 10A shows a differential interferometric microscopy image of the surface morphology of an epi-surface.
FIG. 10B shows a differential interferometric microscopy image of the surface morphology of an epi-surface.
FIG. 10C shows a differential interferometric microscopy image of the surface morphology of an epi-surface.
FIG. 10D shows a differential interferometric microscopy image of the surface morphology of an epi-surface.
FIG. 10E shows a differential interferometric microscopy image of the surface morphology of an epi-surface.
FIG. 10F shows a differential interferometric microscopy image of the surface morphology of an epi-surface.
FIG. 10G shows a differential interferometric microscopy image of the surface morphology of an epi-surface.
FIG. 10H shows a differential interferometric microscopy image of the surface morphology of an epi-surface.
FIG. 10I shows a differential interferometric microscopy image of the surface morphology of an epi-surface.
FIG. 11A shows the surface morphology image of an epi-surface taken by a differential interferometric microscope.
FIG. 11B shows the surface morphology image of an epi-surface taken by a differential interferometric microscope.
FIG. 11C shows the surface morphology image of an epi-surface taken by a differential interferometric microscope.
FIG. 11D shows the surface morphology image of an epi-surface taken by a differential interferometric microscope.
FIG. 11E shows the surface morphology image of an epi-surface taken by a differential interferometric microscope.
FIG. 12A shows the surface morphology image of an epi-surface taken by an atomic force microscope.
FIG. 12B shows the surface morphology image of an epi-surface taken by an atomic force microscope.
FIG. 12C shows the surface morphology image of an epi-surface taken by an atomic force microscope.
FIG. 13A shows the surface morphology image of an epi-surface taken by an atomic force microscope.
FIG. 13B shows the surface morphology image of an epi-surface taken by an atomic force microscope.
FIG. 13C shows the surface morphology image of an epi-surface taken by an atomic force microscope.
FIG. 14A shows the surface morphology image of an epi-surface taken by an atomic force microscope.
FIG. 14B shows the surface morphology image of an epi-surface taken by an atomic force microscope.
FIG. 14C shows the surface morphology image of an epi-surface taken by an atomic force microscope.
FIG. 15A shows the surface morphology image of an epi-surface taken by an atomic force microscope.
FIG. 15B shows the surface morphology image of an epi-surface taken by an atomic force microscope.
FIG. 15C shows the surface morphology image of an epi-surface taken by an atomic force microscope.
FIG. 15D is a pattern diagram depicting an atomic step terrace structure in the atomic force microscopy image of FIG. 15A.
FIG. 15E is a pattern diagram depicting an atomic step terrace structure in the atomic force microscopy image of FIG. 15B.
FIG. 15F is a pattern diagram depicting an atomic step terrace structure in the atomic force microscopy image of FIG. 15C.
FIG. 15G is a view showing an epitaxial laminate structure providing the atomic step terrace structure in the atomic force microscopy image of FIG. 15A.
FIG. 15H is a view showing an epitaxial laminate structure providing the atomic step terrace structure in the atomic force microscopy image of FIG. 15B.
FIG. 15I is a view showing an epitaxial laminate structure providing the atomic step terrace structure in the atomic force microscopy image of FIG. 15C.
FIG. 16A shows the surface morphology image of an epi-surface taken by an atomic force microscope.
FIG. 16B shows the surface morphology image of an epi-surface taken by atomic force microscopy.
FIG. 16C shows the surface morphology image of an epi-surface taken by an atomic force microscope.
FIG. 17A shows the surface morphology image of an epi-surface taken by an atomic force microscope.
FIG. 17B shows the surface morphology image of an epi-surface taken by an atomic force microscope.
FIG. 17C shows the surface morphology image of an epi-surface taken by an atomic force microscope.
FIG. 17D is a pattern diagram depicting the surface morphology shown in FIG. 17A.
FIG. 17E is a pattern diagram depicting the surface morphology shown in FIG. 17B.
FIG. 18A shows the surface morphology image of an epi-surface taken by an atomic force microscope.
FIG. 18B shows the surface morphology image of an epi-surface taken by an atomic force microscope.
FIG. 18C shows the surface morphology image of an epi-surface taken by an atomic force microscope.
FIG. 18D is a pattern diagram depicting an atomic step terrace structure in the atomic force microscopy image of FIG. 18A.
FIG. 18E is a pattern diagram depicting an atomic step terrace structure in the atomic force microscopy image of FIG. 18B.
FIG. 18F is a pattern diagram depicting an atomic step terrace structure in the atomic force microscopy image of FIG. 18C.
FIG. 19A shows the surface morphology of an epi-surface taken by an atomic force microscope.
FIG. 19B shows the surface morphology of an epi-surface taken by an atomic force microscope.
FIG. 19C is a pattern diagram showing an atomic step terrace structure in the atomic force microscopy image of FIG. 19A.
FIG. 19D is a pattern diagram showing an atomic step terrace structure in the atomic force microscopy image of FIG. 19B.
FIG. 20A shows the surface morphology of an epi-surface taken by an atomic force microscope.
FIG. 20B shows the surface morphology image of an epi-surface taken by an atomic force microscope.
FIG. 20C shows the surface morphology image of an epi-surface taken by an atomic force microscope.
FIG. 20D is a pattern diagram depicting an atomic step terrace structure in the atomic force microscopy image of FIG. 20A.
FIG. 20E is a pattern diagram depicting an atomic step terrace structure in the atomic force microscopy image of FIG. 20B.
FIG. 20F is a pattern diagram depicting an atomic step terrace structure in the atomic force microscopy image of FIG. 20C.
FIG. 21A shows the surface morphology image of an epi-surface taken by an atomic force microscopy.
FIG. 21B shows the surface morphology image of an epi-surface taken by an atomic force microscope.
FIG. 21C shows the surface morphology image of an epi-surface taken by an atomic force microscope.
FIG. 21D shows the surface morphology image of an epi-surface taken by an atomic force microscope.
FIG. 21E shows the surface morphology image of an epi-surface taken by an atomic force microscope.
FIG. 21F shows the surface morphology image of an epi-surface taken by an atomic force microscope.
FIG. 22A shows the peak energy distribution of cathode luminescence (CL) from the surface of a two-layered electron injection structure according to the embodiment.
FIG. 22B shows the peak energy distribution of cathode luminescence (CL) from the surface of a single-layered electron injection structure according to an embodiment.
FIG. 23A is a diagram showing an X-ray diffraction (X-ray Diffraction: XRD) reciprocal space mapping (Reciprocal Space Mapping: RSM) image.
FIG. 23B is a diagram showing an X-ray diffraction (XRD) reciprocal space mapping (RSM) image.
FIG. 24 shows the secondary ion mass spectrometry (SIMS) analysis profile of the nitride semiconductor laminate (two-layered electron injection structure) according to the embodiment.
FIG. 25A shows the relationship between the characteristics of a light-emitting diode according to the embodiment and the in-plane lattice constant of the electron injection layer thereof.
FIG. 25B shows the relationship between the characteristics of a light-emitting diode according to the embodiment and the in-plane lattice constant of the electron injection layer thereof.
FIG. 25C shows the relationship between the characteristics of a light-emitting diode according to the embodiment and the in-plane lattice constant of the electron injection layer thereof.
FIG. 25D shows the relationship between the characteristics of a light-emitting diode according to the embodiment and the in-plane lattice constant of the electron injection layer thereof.
FIG. 25E shows the relationship between the characteristics of a light-emitting diode according to the embodiment and the in-plane lattice constant of the electron injection layer thereof.
FIG. 25F shows the relationship between the characteristics of a light-emitting diode according to the embodiment and the in-plane lattice constant of the electron injection layer thereof.
FIG. 25G shows the relationship between the characteristics of a light-emitting diode according to the embodiment and the in-plane lattice constant of the electron injection layer thereof.
FIG. 25H shows the relationship between the characteristics of a light-emitting diode according to the embodiment and the in-plane lattice constant of the electron injection layer thereof.
FIG. 26A shows the relationship between the Al molar fraction of the active layer and the total polarization (both of spontaneous and piezo polarizations).
FIG. 26B shows the relationship between the Al molar fraction of the active layer and the total polarization (both of spontaneous and piezo polarizations).
FIG. 26C shows the relationship between the Al molar fraction of the active layer and the total polarization (the sum of spontaneous and piezo polarizations).
FIG. 27A shows emission spectrums of light emitting diodes according to the reference example and the present embodiment.
FIG. 27B shows emission spectrums of light emitting diodes according to the reference example and the present embodiment.

### DESCRIPTION OF EMBODIMENTS

Embodiments for carrying out the present invention with reference to the drawings will be described below. The same and similar portions are denoted by the same and similar reference numerals so as to omit duplicate description.

Light-emitting devices encompass a semiconductor device, such as, a light-emitting diode, semiconductor laser, and light source by electron-beam pumping, that includes an active layer comprising a III nitride to emit light and includes an n-type semiconductor layer comprising a III nitride, and, if needed, a p-type semiconductor layer comprising a III nitride.

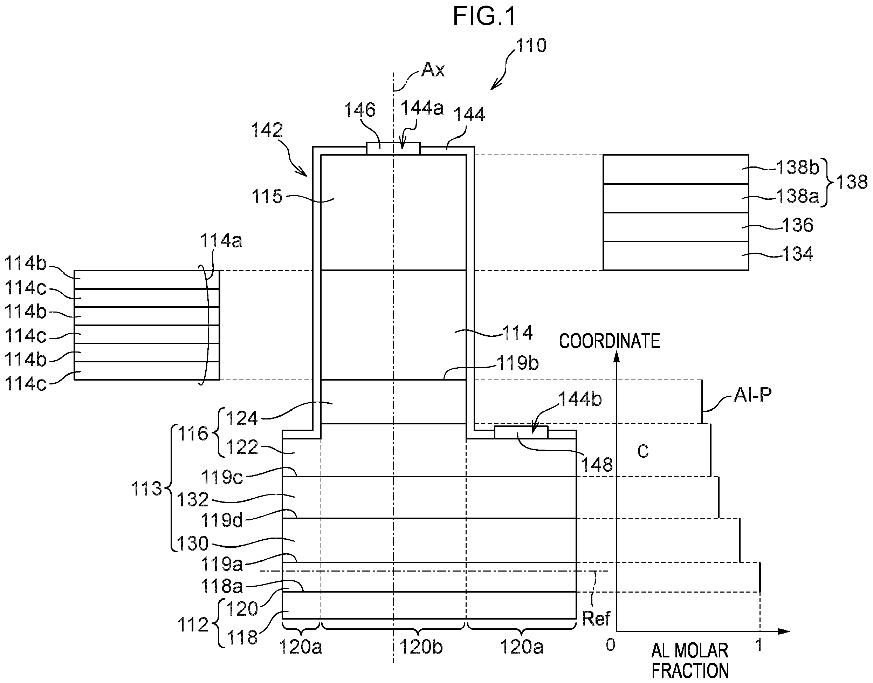

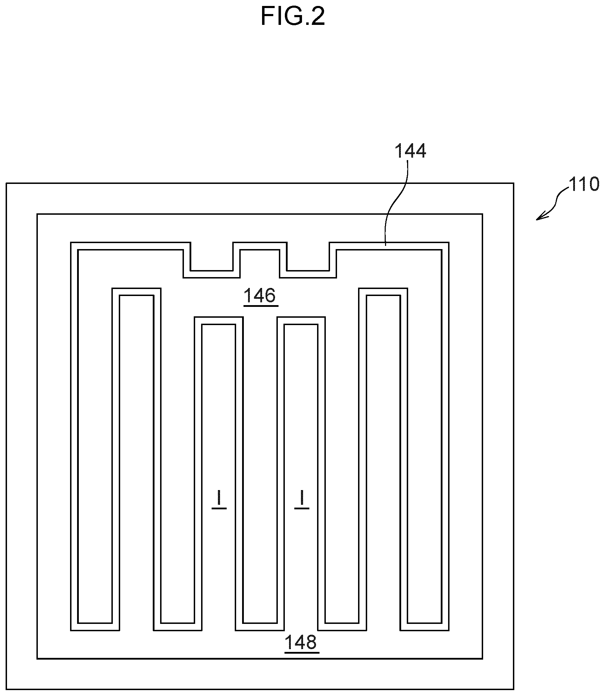

FIG. 1 is a schematic diagram showing a light-emitting device according to an embodiment of the invention. FIG. 2 is a diagram showing a light-emitting device according to the embodiment. FIG. 1 shows a cross section taken along the line I-I of FIG. 2. In the subsequent description, the light emitting device 110 has a structure of an exemplary light emitting diode.

Referring to FIG. 1, the light emitting device 110 includes a template member 112, an active layer 114, and an n-type III nitride semiconductor region (hereinafter referred to as "nitride semiconductor region") 116 which supplies carriers to the active layer 114. The template member 112 includes a support 118 and a template layer 120. The support 118 has a principal surface 118a made of a material that differs from III nitride. The template layer 120 includes an Al_{X}Ga_{1-X}N (X is greater than 0 and less than or equal to 1) and covers the principal surface 118a of the support 118. In the Al_{X}Ga_{1-X}N, the full width at half maximum of a (10-12)-face X-ray rocking curve may be less than or equal to, for example, 1000 arcsec, and the AlxGai-xN includes compressive strain. This compressive strain is a source of strain to be applied to the active layer 114. The template layer 120 can have a thickness of, for example, 2000 nm or less and 100 nm or more and may be, for example, 500 nm thick. The Al_{X}Ga_{1-X}N of the template layer 120 can be an AlN (at X=1), which provides, with AlN, the template layer 120 that is compressively strained.

By way of example and not limitation, the support 118 may include at least one of carbon, boron nitride (BN), aluminum oxide (sapphire), ceramics, silicon carbide, refractory metals, zirconia, tantalum carbide (TaC), and ScAlMgO₄. The support 118 can be provided with, for example, a hexagonal crystal structure, and the principal surface 118a of the support 118 has, by way of example and not limitation, an off-angle of 0.5 degrees or less with respect to the c-face of the crystal structure.

The active layer 114 is disposed on the template member 112 so as to generate light having a peak wavelength in the deep ultraviolet wavelengths of 285 nm or below, and include AlGaN that incorporate compressive strain.

The nitride semiconducting region 116 is disposed between the template member 112 and the active layers 114, and includes Al as a III constituent element. The nitride semiconductor region 116 may include a plurality of n-type III nitride semiconductor layers, for example, an n-type first III nitride semiconductor layer (hereinafter referred to as "n-type 1st semiconductor layer ") 122 and an n-type second III nitride semiconductor layer (hereinafter referred to as "n-type 2nd semiconductor layer") 124. The n-type 1st semiconductor layer 122 is disposed between the template layer 120 and the active layer 114, and the n-type 2nd semiconductor layer 124 is disposed between the n-type 1st semiconductor layer 122 and the active layer 114. The n-type 1st semiconducting layer 122 has a lattice relaxation rate of 2% or less with respect to the template layer 120. This lattice relaxation rate is measured by X-ray diffraction reciprocal space mapping (XRD-RSM) with an X'pert3 MRD instrument (Malvern Panalytical, Malvern, UK). The n-type 2nd semiconductor layer 124 has a surface roughness of 0.4 nm or less (in RMS). The surface roughness (RMS) is measured by atomic force microscopy (AFM) (measuring instrument: MFP-3D Origin+ (Oxford Instruments, Abington, UK)).

In the light-emitting device 110, the n-type 2nd semiconductor layer 124, which is disposed on the n-type 1st semiconductor layer 122, is provided with a surface roughness of 0.4 nm or less. This small surface roughness can avoid the occurrence of lattice relaxation of the active layer 114, which allows the compressive strain to be brought to the active layer 114. Further, the template layer 120 is provided with AlxGai-xN in which the full width at half maximum of the (10-12)-face X-ray rocking curve is not greater than 1000 arcsec, and the n-type 1st semiconductor layer 122 can be disposed thereon and is provided with a lattice relaxation rate of 2% or less. Such a low lattice relaxation rate allows the application of the compressive strain of Al_{X}Ga_{1-X}N of the template layer 120 to the active layer 114.

The active layer 114 can be configured to have an emission spectrum of a full width at half maximum which is less than or equal to 10 nm. Specifically, by way of illustration and not limitation, the active layer 114 may consist of a single layer of AlGaN or have a single or multiple quantum-well structure 114a. The multiple quantum-well structure 114a include well layers 114b with compressive strain, and barrier layers 114c with compressive strain. In the light-emitting device 110, the compressive strains of the well and barrier layers 114b and 114c can enhance the emission power of the active layer 114 by the action of the quantum-confined Stark effect.

When the n-type 2nd semiconducting layer 124 of a low surface roughness (RMS) forms a junction with the active layer 114, which allows compressive strain from the template layer 120 to be effectively applied to the active layer 114. Specifically, AlGaN of the well layer 114b of the active layer 114 may be provided with a compressive strain of 1.5% or more. The magnitude of compressive strain of the template layer 120 is designed to suppress warping of the template substrate, which may be caused by high temperature heat treatment. It can be set to 2% or less so that the warpage is suppressed for epitaxial growth, and the Al content of the well layer 114b that allows the emission of wavelengths of 285 nm or less is increased. This compressive strain can be evaluated by X-ray reciprocal space mapping (XRD-RSM) and was measured using the X'pert3 MRD (Malvern Panalytical, Malvern, UK) as an apparatus.

The active layer 114 is formed on a nitride semiconductor region, which is in contact with the template layer 120, of a low lattice relaxation rate, so that the compressive strain is applied to the quantum well 114a. The compressive strains of the well and barrier layers 114b and 114c reduces the difference in polarizations between the well and barrier layers 114b and 114c.

Specifically, the well-layer 114b may include undoped AlGaN, and the barrier layer 114c may include undoped AlGaN. AlGaN of the barrier layer 114c has a larger band gap than that of AlGaN of the well layer 114b. The barrier layer 114c may include an AlN, if desired.

The n-type 1st semiconductor layer 122 can be an AlGaN layer the Al molar fraction of which is 0.7 or more, and the n-type 2nd semiconductor layer 124 can be an AlGaN layer the Al molar fraction of which is 0.7 or more. These Al molar fractions ranges allow the application of compressive strain to the active layer 114.

By way of illustration and not limitation, the n-type 1st semiconductor layer 122 may include AlGaN or InAlGaN, and the n-type 2nd semiconductor layer 124 may include AlGaN or InAlGaN. Specifically, the n-type 2nd semiconducting layer 124 may have an Al compositional variation of 0.1% or less. The reason why the compositional variation can be reduced within this range is that the surface morphology affects the uptake efficiency of Ga element. In other words, a poor flatness thereof causes the molar fraction variation. The surface flatness of an underlying layer, which is associated with the Al compositional variation, has a great influence on the molar fraction of the active layer growing thereon in the complex combination of the molar fractions and film thicknesses. When the Al compositional variation is, for example, 0.16%, the active layer 114 is provided with the Al compositional variation of about 2 times as large as that of 0.09%. The Al compositional variation of the n-type 2nd semiconductor layer 124 is smaller than that of the n-type 1st semiconductor layer 122.

By way of illustration and not limitation, the thickness of the n-type 1st semiconductor layer 122 may be greater than that of the n-type 2nd semiconductor layer 124. In the light-emitting device 110, this magnitude relationship in thickness can prevent the lattice relaxation of the n-type 1st and 2nd semiconductor layers 122 and 124 on the template layer 120, for example, lattice relaxation of AlGaN layers, from occurring, thereby forming the active layer 114 that is compressively strained. The thickness of the nitride semiconducting region 116 can range, for example, from 200 to 3000 nm. The thickness of the n-type 2nd semiconducting layer 124 can range from 10 to 200 nm, and more preferably 50 to 150 nm.

Specifically, the film thickness of the n-type 1st semiconductor layer 122 is 2800 nm or less, and the film thickness of the n-type 2nd semiconductor layer 124 is 200 nm or less. These ranges of the thicknesses can avoid lattice relaxation of AlGaNs of the n-type 1st and 2ndsemiconductor layers 122 and 124 to facilitate the growth of, onto the template layer 120, the active layer 114 that incorporates the compressive strain. In this example, the n-type 1st semiconductor layer 122 can be in direct contact with the n-type 2nd semiconductor layer 124, and the n-type 2nd semiconductor layer 124 can be in direct contact with the active layer 114.

By way of example and not limitation, the n-type 2nd semiconductor layer 124 may have a smaller Al molar fraction than that of the n-type 1st semiconductor layer 122. Alternatively, the n-type 2nd semiconductor layer 124 may have an Al molar fraction substantially equal to that of the n-type 1st semiconductor layer 122.

The light-emitting device 110 has a lower III nitride laminate 113, which is located between the active layer 114 and the template member 112, and an upper III nitride laminate 115, which is located above the active layer 114. In the present embodiment, the lower III nitride laminate 113 forms a junction 119a with the template layer 120 to apply compressive strain from Al_{X}Ga_{1-X}N of the template layer 120 thereto. The lower III nitride laminate 113 also forms a junction 119b with the active layers 114. The active layer 114 may incorporate compressive strain from Al_{X}Ga_{1-X}N of the template layer 120. However, at least a portion of the upper III nitride laminate 115 may be lattice-relaxed. This upper III nitride laminate 115 is disposed on the active layer 114 to supply carriers to the active layer 114.

The lower III nitride laminate 113 may include one or more III nitride semiconductor layers in addition to the nitride semiconductor regions 116.

Specifically, the lower III nitride laminate 113 may include an underlying layer, e.g., an Al_{U}Ga_{1-U}N layer 130 (U is less than or equal to X, greater than zero). The Al_{U}Ga_{1-U}N layer 130 can be, for example, undoped and can be formed to cover the template layer 120. Specifically, the Al_{U}Ga_{1-U}N layer 130 may be made of AlN.

By way of example and not limitation, the Al_{U}Ga_{1-U}N layer 130 may have a density of spiral dislocations of, for example, up to 4×10⁶ cm⁻². The Al_{U}Ga_{1-U}N layer 130 may have a density of threading dislocations of, for example, 9×10⁸ cm⁻² or less. The undoped Al_{U}Ga₁₋uN layer 130 may also include compressive strain. The lattice relaxation rate of Al_{U}Ga_{1-U}N layer 130 relative to the template layer 120 is less than 2%. The light emitting device 110 allows the Al_{U}Ga_{1-U}N layer 130 to inherit the density of dislocations from the template layer 120 and to fully receive compressive distortion from the template layer 120.

The lower III nitride laminate 113 may include another underlying layer, specifically Al_{V}Ga_{1-V}N layer 132, where V is less than 1 and greater than 0.8 and V is less than U. The Al_{V}Ga_{1-V}N layer 132 may be, for example, undoped, and specifically may be made of AlGaN. The Al_{V}Ga_{1-V}N layer 132 may be provided on the Al_{U}Ga_{1-U}N layer 130. The Al_{V}Ga_{1-V}N layer 132 may have a density of dislocations including, for example, a density of spiral dislocations of 4×10⁶ cm⁻² or less. The Al_{V}Ga_{1-V}N layer 132 may incorporate compressive strain from the base. When the template layer 120 is made of AlN, the lattice relaxation rate of AluGai-uN layer to template layer 120 is less than 2%. The light emitting device 110 allows the Al_{V}Ga_{1-V}N layer 132 to lower an Al molar fraction toward the active layer 114, while causing the Al_{V}Ga_{1-V}N layer 132 to inherit the density of dislocations from the template layer 120 and maintain the compressive strain from the template layer 120.

In the lower III nitride laminate 113, the lattice relaxation rate of the n-type 2nd semiconducting layer 124 to the template layer 120 can be 2% or less. The lower III nitride laminate 113 is connected to an electrode (an n-side electrode 148). In this instance, current flows through the lower III nitride laminate 113 in the in-plane direction. When the film thickness of the n-type semiconductor region becomes large, the resistance thereof becomes lower, thereby reducing the driving voltage. However, too large thickness of the n-type semiconductor region may increase the lattice relaxation rate thereof, thereby preventing compressive strain from being effectively applied to the active layer. The lattice relaxation rate of less than 2% in the n-type 2nd semiconductor layer 124 allows the n-type semiconductor to have a film thickness for an excellent current path and the compressive strain to be effectively applied to the active layer.

In this embodiment, the nitride semiconductor region 116 forms a junction 119c with the Al_{V}Ga_{1-V}N layer 132. The Al_{V}Ga_{1-V}N layer 132 forms a junction 119d with an Al_{U}Ga_{1-U}N layer 130. The lower III nitride laminate 113 includes an Al_{U}Ga_{1-U}N layer 130 and an Al_{V}Ga_{1-V}N layer 132 in addition to the nitride semiconductor region 116. The AluGai-uN and Al_{V}Ga_{1-V}N layers 130 and 132 form underlying layers, which can apply the compressive distortion of the template layer 120 to active layer 114. The nitride semiconducting region 116 has an Al molar fraction which is less than that of Al_{V}Ga_{1-V}N layers 132 and greater than that of the well layers 114b.

The lower III nitride laminate 113 has an Al compositional profile Al-P that varies monotonically in the direction from the template member 112 to the active layer 114 (including stepwise variations in the same direction). This Al compositional profile Al-P ensures that when the Al molar fraction of the template layer 120 is greater than that of the well layer 114b, the Al molar fraction does not increase in the direction from the template layer 120 to the active layer 114.

Subsequently, the upper III nitride laminate 115 is described below. The upper III nitride laminate 115 may include, for example, an electron block layer 134, a p-type compositionally-graded layer 136, and a p-type contact layer 138. The electron block layer 134, p-type compositionally-graded layer 136, and p-type contact layer 138 (138a and 138b) can be disposed on the active layer 114 in this order.

An exemplary upper III nitride laminate 115 is illustrated below. Even when not described as "by way of example and not limitation", numerical values in the following description each are usually intended to allow a certain range, and are shown by way of example and not limitation.
Electron block layer 134: undoped or Mg doped AlN, thickness 5 nm
P-type compositionally-graded layer 136: Mg-doped compositionally-graded AlGaN (Al molar fraction: 0.9 to 0.3), 12 nm thick
P-type contact layer 138a (as the first layer): Mg doped GaN, 120 nm thick
P-type contact layer 138b (as the second layer): Mg heavily-doped GaN, 30 nm thick

The light-emitting device 110 has a processed region 142, which is formed by e.g., etching. The region 142 thus processed may be provided with the upper III nitride laminate 115, the active layer 114, and the upper portion of the nitride semiconductor region 116 (specifically, the n-type 2nd semiconductor layer 124 and an upper portion of the n-type first semiconductor layer 122).

The light-emitting device 110 may further include a passivation film 144, which covers the nitride semiconductor region 116 and the region 142, which may be processed by etching. The passivation film 144 has a first opening 144a and a second opening 144b. The first opening 144a is located on the top surface of the region 142, which is processed by etching, and the second opening 144b is located on the upper surface of the nitride semiconductor region 116 (specifically, the upper surface of the n-type first semiconductor layer 122). The passivation film 144 may include, for example, a silicon-based inorganic insulator, which specifically may include silicon oxide, silicon nitride, or silicon oxynitride.

The light-emitting device 110 may include a p-side electrode 146 and an n-side electrode 148. The p-side electrode 146 is disposed in the first opening 144a, and the n-side electrode 148 is disposed in the second opening 144b. The p-side electrode 146 makes contact with the top surface of the p-type contact layer 138. The n-side electrode 148 makes contact with the upper surface of the n-type 1st semiconductor layer 122.
P-side electrode 146: Ni/Au ("Ni/Au" means depositing Au on the top of Ni)
N-side electrode 148: Ti/Al/Ni/Au

The template layer 120 has a first region 120a and a second region 120b, which are arranged along a reference plane Ref that intersects the axis Ax, which extends from the template layer 120 toward the active layer 114. The n-side electrode 148 is located on the first area 120a, specifically on the lower III nitride laminate 113, and the p-side electrode 146 and the region 142, processed by etching, are located on the second region 120b, specifically on the surface of the upper III nitride laminate 115. As shown in FIG. 2, the p-side electrode 146 may have a comb shape. The n-side electrode 148 may has a comb-shaped portion, and a closed portion so as to surround the processed region 142.

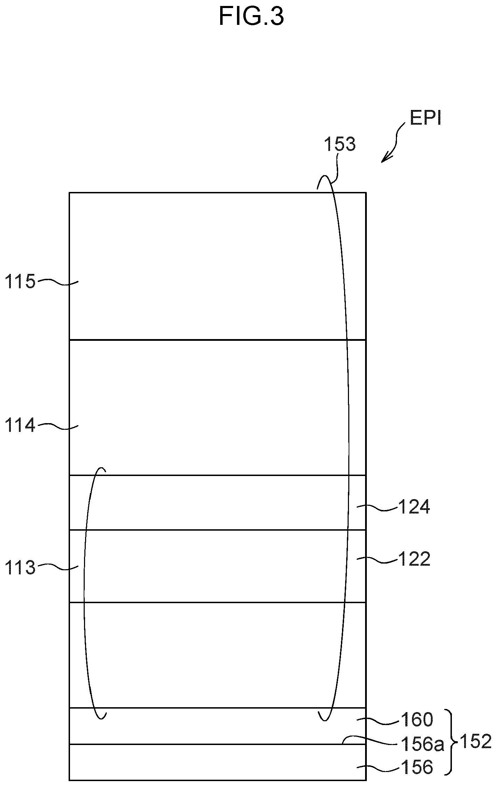

FIG. 3 is a schematic view illustrating a III nitride epitaxial wafer according to the embodiment.

The III nitride epitaxial wafer (hereinafter referred to as the "epitaxial wafer") EPI does not include any passivation film 144, p-side electrodes 146 and n-side electrodes 148, and also includes a semiconductor layer structure 153 that includes the same semiconducting films as the lower III nitride laminate 113, active layer 114, and upper III nitride laminate 115 of the light-emitting device 110. Accordingly, the epitaxial wafer EPI is provided with a template substrate 152, and semiconducting films for the lower III nitride laminate 113, the active layer 114, and the upper III nitride laminate 115, which are disposed on the template substrate 152.

The template substrate 152 includes a substrate 156 with a principal face 156a made of material that differs from III nitride, and a template layer 160, formed thereon, which includes compressive strain and overlies the major face 156a of the substrate 156. In the template substrate 152, the template layer 160 includes Al_{X}Ga_{1-X}N (X is greater than 0, and 1 or less) in which a half width at half maximum of the (10-12)-face X-ray rocking curve is less than or equal to 1000 arcsec, and which covers the major face 156a of the substrate 156, and includes compressive strain. The substrate 156 may include at least one of the following materials: carbon, boron nitride (BN), aluminum oxide (sapphire), ceramics, silicon carbide, refractory metals, zirconia, tantalum carbide (TaC), and ScAlMgO₄. The substrate 156 has, for example, a hexagonal crystal structure, and the principal face 156a of the substrate 156 has an off-angle of 0.5 degrees or less with respect to the c-face of the crystal structure.

The epi-wafer EPI provides the n-type 2nd semiconductor layer 124 on the n-type 1st semiconductor layer 122 with the surface roughness of 0.4 nm or less. This low surface roughness can prevent lattice relaxation from occurring in the active layer 114 to impart the compressive strain to the active layer 114. Further, the n-type 1st nitride layer 122 with a lattice relaxation rate of 2% or less is disposed on the template layer 160 of AlxGai-xN in which the half width at half maximum of the (10-12)-face X-ray rocking curve is 1000 arcsec or less. This low lattice relaxation rate enables the compressive strain, which is contained in the template layer, to be applied to the active layer.

A semiconductor layer structure 153 is disposed on the template substrate 152. Accordingly, the semiconductor layer structure 153 is associated with semiconductor layers, which are denoted by the same reference numerals as those of the light-emitting device 110, and duplicate description is omitted.

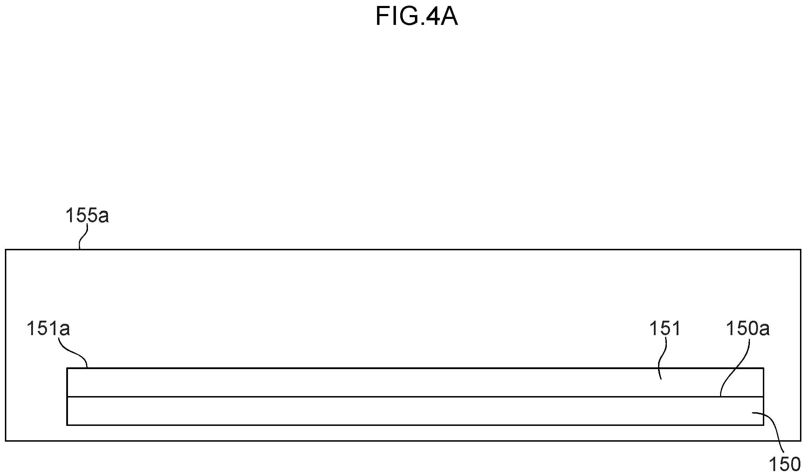

FIGs. 4A, 4B, 5A, 5B, 6A, 6B, 7A, and 7B are views showing the major steps of the method for fabricating a light emitting device according to the present embodiment. In the subsequent description of the fabrication method, a light-emitting diode structure is fabricated as an exemplary light emitting device.

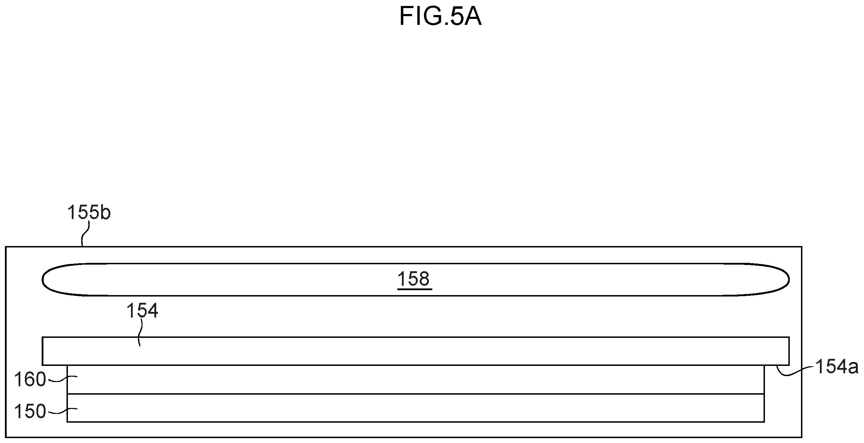

As shown in FIGs. 4A to 5B, a template 162 is prepared. Preparing the template 162 may include, for example, making the template 162 or obtaining the template 162 by methods other than fabrication.

Making the template 162 may include the steps shown below.

In the process in FIG. 4A, a substrate 150 is prepared. The substrate 150 can be, for example, a 2-inch size sapphire substrate. The substrate 150 is placed in the deposition apparatus, and a precursor 151 for AlxGai-xN is deposited on the major face 150a of the substrate 150. The deposition is performed by sputtering using, for example, a sputtering apparatus 155a. The precursor 151 includes granular III nitride crystal of Al_{X}Ga_{1-X}N. A sputtering target includes AlN or AlGaN. The target is sputtered at a sputtering pressure of 0.05 Pa to deposit AlN or AlGaN precursors 151 of the template layer on the substrate 150. In forming this film, the surface temperature of the substrate 150 is maintained at a temperature in a range of about 500 to 700 degrees Celsius, for example, about 700 degrees Celsius. As an inert gas, for example, nitrogen gas is used, and a flow rate of the nitrogen gas is, for example, 10 to 100 sccm (standard cubic centimeter per minute).

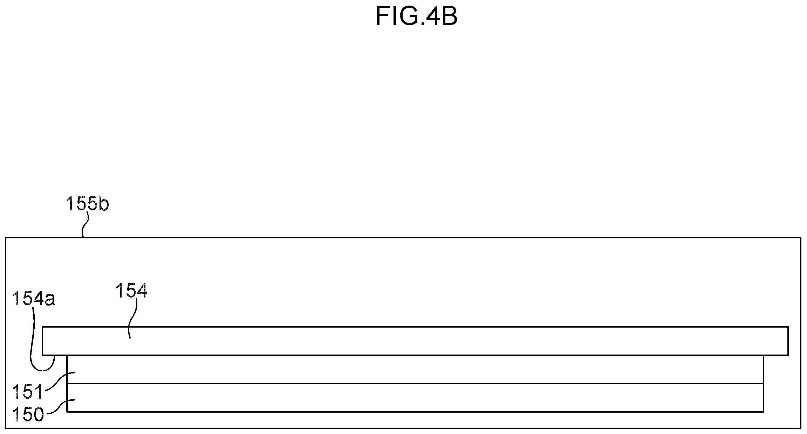

In the process of FIG. 4B, after depositing the precursor 151, the substrate 150 and the precursor 151 are placed in the thermal processing apparatus 155b. In the thermal processing apparatus 155b, the covering member 154 and the precursors 151 are placed opposite to each other. In placing them, the covering member 154 and the precursor 151 are arranged so that the largest distance between the major face 152a of the precursor 151 and the major face 154a of the covering member 154 may be equal to or smaller than 0.5 mm.

In the process of FIG. 5A, the heat treatment of the substrate 150 and the precursors 151 is performed using the heat treatment apparatus 155b. In the heat treatment apparatus 155b, an atmosphere 158 is formed which includes either an inert gas or a mixed gas containing an inert gas and ammonia (NH₃). The temperature of the substrate 150 and precursor 151 is raised to an annealing temperature in the atmosphere 158. The annealing temperature may range, for example, from 1600 to 1750 degrees Celsius, and can be, for example, 1725 degrees Celsius. In addition, the temperature of the substrate 150 and the precursor 151 may be maintained at 1400 degrees Celsius or more for 20 minutes to 168 hours, and more preferably 3 to 48 hours. In the heat treatment apparatus 155b, the substrate 150 and precursor 151 are placed in the above-described temperature range, and are subjected to the heat treatment, for example, for 20 minutes or more. This heat treatment can form the template 162 that includes the template layer 160. The template layer 160 includes an Al_{X}Ga_{1-X}N (X is greater than zero and less than or equal to one) and covers the major face 150a of the substrate 150. The template layer 160 may be, for example, less than or equal to 2000 nm, and equal to or greater than 100 nm in thickness, and in this example, can be 500 nm in thickness.

The covering member 154 may have a major face 154a that has a large area which is greater than or equal to that of the major face 151a of the precursors 151. The major face 154a of the covering member 154 may include at least one of carbon, boron nitride (BN), aluminum oxide (sapphire), ceramics, silicon carbide, refractory metals, zirconia, tantalum carbide (TaC), and ScAlMgO₄. The inert gas of the atmosphere 158 may include at least one of helium (He), nitrogen (N₂), and argon (Ar).

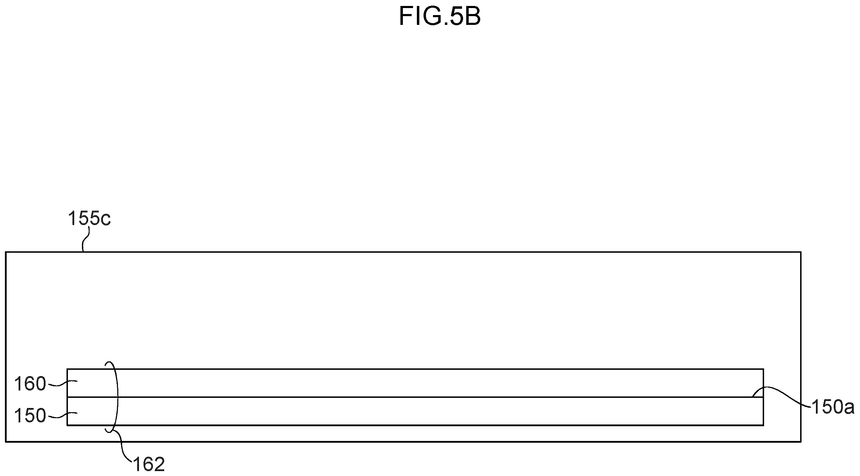

In the process of FIG. 5B, a (10-12)-face X-ray rocking curve is measured using an X-ray diffractometer 155c to obtain the half width at half maximum of the curve. The template layer 160 has a full width at half maximum of the (10-12)-face X-ray rocking curve of not more than 1000 arcsec. These steps complete the template 162 from the substrate 150.

The above exemplary process of preparing the template 162 can provide the template layer 160 with a half width at half maximum of a (0002)-face X-ray rocking curve of 100 arcsec or less, instead of the (10-12)-face X-ray rocking curve.

The sputtering deposition and the high temperature heat treatment can be used to form the template layer 160.

The template 162 thus prepared is provided with the substrate 150 and the template layer 160. The substrate 150 has a major face 150a made of material that differs from III nitride. The template layer 160 is provided with the Al_{X}Ga_{1-X}N, in which the half width at half maximum of the (10-12)-face on the X-ray rocking curve is not more than 1000 arcsec, to cover the major face 150a of the substrate 150.

The Al_{X}Ga_{1-X}N template layer 160 can be, in particular, AlN and/or AlGaN. The template layer 160 is also provided with the density of dislocations that include the spiral component of not more than 5×10⁷ cm⁻², the density of threading dislocations of 9×10⁸ cm⁻² or less.

The substrate 150 may include at least one of the following materials: carbon, boron nitride (BN), aluminum oxide (sapphire), ceramics, silicon carbide, refractory metals, zirconia, tantalum carbide (TaC), and ScAlMgO₄. For example, sapphire substrates can typically have a size of 2 inches.

Specifically, the substrate 150 may have a hexagonal crystal structure. The principal surface 152a of the substrate 150 has an off-angle of 0.5 degrees or less, and greater than zero degrees relative the c-face of the crystal structure. The off-angle is taken in an off-direction, for example, the direction of [1-100] (m-axis direction) of the crystal structure of the hexagonal system. This fabrication method provides the off angle with exemplary angular range and off-direction.

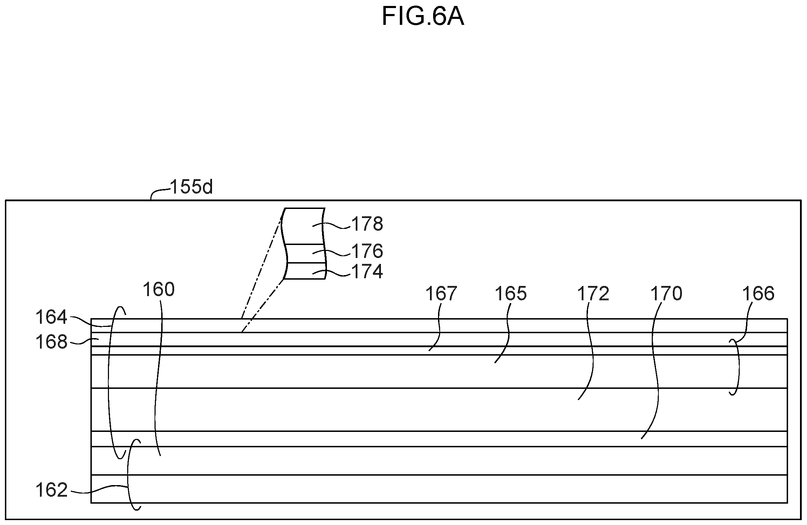

In the process of FIG. 6A, a III nitride laminate 164 is grown over the template layer 160. This growth can be carried out, for example, by a metalorganic vapor phase epitaxy

(MOVPE) method or a molecular beam epitaxy (MBE) method. In the subsequent discussion, an MOVPE reactor 155d is used in which trimethylgallium (TMGa) and trimethylaluminum (TMAl) are used as gallium and aluminum precursors, respectively and NH₃ is used as a nitrogen-source.

The III nitride laminate 164 includes semiconductor films for lower III nitride laminate 113 and the active layer 114. Specifically, the III nitride laminate 164 has a nitride semiconductor region 166 and an active layer 168.

After making the template layer 160, the nitride semiconductor region 166 is grown on the template layer 160. Specifically, the n-type 1st semiconductor layer 165 is grown on the template layer 160, and the n-type 2nd semiconductor layer 167 is grown on the n-type 1st semiconductor layer 165.

Growing the III nitride laminate 164 over the template layer 160 may include growing the n-type 1st semiconductor layer 165 and the n-type 2nd semiconductor layer 167 using at least one of the following conditions.

First condition: the growth temperature T165 of the growth of the n-type 1st semiconductor layer 165 is higher than the growth temperature T167 of the growth of the n-type 2nd semiconductor layer 167 (i.e., T165>T167).

Second condition: the growth rate V165 of the growth of n-type 1st semiconductor layer 165 is smaller than the growth rate V167 of the growth of the n-type 2nd semiconductor layer 167 (i.e., V167>V165).

Third condition, the NH₃ partial pressure P165 of the growth of the n-type 1st semiconductor layer 165 is higher than the NH₃ partial pressure P167 of the growth of the n-type 2nd semiconductor layer 167 growth (i.e., P165>P167).

This growing process allows the growth of the n-type 1st and 2nd semiconductor layers 165 and 167 on the template layer 160 of Al_{X}Ga_{1-X}N, the full width at half maximum of a (10-12)-face X-ray locking curve of which is 1000 arcsec, in the at least one condition of the first to third conditions.

The n-type 1st semiconductor layer 165 thus grown can suppress the generation of hillocks and dislocations due to the screw dislocation. Further, the n-type 2nd semiconductor layer 167 thus grown can be provided with a more excellent flatness than that of the n-type 1st semiconductor layer 165.

Exemplary n-type 1st and 2nd semiconductor layers 167 and 165 each include an n-type dopant (e.g., silicon).

After growing the nitride semiconductor region 166, the active layer 168 is grown thereon. Specifically, the active layers 168 may comprise AlGaN. The active layer 168 can be configured to generate light having a peak wavelength in the deep ultraviolet wavelengths of not more than 285 nm. By way of example and not limitation, the active layer 168 can generate light up to a peak wavelength of 210 nm in the deep ultraviolet light wavelengths. By way of example and not limitation, the active layer 168 may comprise InAlGaN capable of generating light in the deep ultraviolet wavelengths.

The n-type 1st and 2nd semiconductor layers 165 and 167, and the active layer 168 are grown on the template layer 160 to form the following structures. The n-type 1st and second semiconductor layers 167 and 165 are provided in the nitride semiconductor region 166. The n-type 1st semiconductor layer 165 is disposed between the template layer 160 and the active layer 168, and the n-type 2nd semiconductor layer 167 is disposed between the n-type 1st semiconductor layer 165 and the active layer 168. The active layers 168 includes III nitride semiconductor that incorporates compressive strain.

The growth of AlGaN of the active layer 168 on the III nitride laminate 164 is carried out on the excellent surface of the underlying n-type 2nd semiconductor layer 167 to enable the formation of the active layer 168, which is compressively strained. The compressively strained active layer 168 can enhance the optical output of the emission (optical output per input power) in the deep ultraviolet wavelengths of not more than 285 nm.

This fabrication method provides, by way of example and not limitation, the following growth temperatures for the first condition. The exemplary growth temperature of the n-type 1st semiconductor layer 165 can be 1100 degrees Celsius or higher, and the exemplary growth temperature of the n-type 2nd semiconductor layer 167 can be 1100 degrees Celsius or lower.

Growth in higher temperatures is less likely to produce hillocks on the underlying region, which inherits distortions from the template layer 160. Growth in the lower temperatures can improve the disturbed step-flow structure that has been formed in the growth at the higher temperatures. This improvement can reduce the in-plane compositional non-uniformity of constituent elements of the n-type 2nd semiconductor layer 167 (e.g., n-type AlGaN layer). The reduction of the compositional non-uniformity can provide, with a high compositional uniformity of the constituent elements, a base on which the active layer 168 is grown.

Further, by way of example and not limitation, the growth temperature of the n-type 1st semiconductor layer 165 may be 1200 degrees Celsius or less, and the growth temperature of the n-type 2nd semiconductor layer 167 may be 1000 degrees Celsius or more.

The present fabrication method provides, by way of example and not limitation, the following growth rates for the second condition. The growth rate of the n-type 1st semiconductor layer 165 may be 400 nm/h or less, and the growth rate of the n-type 2nd semiconductor layer 167 may be greater than 400 nm/h.

Growth in lower growth rates is less likely to produce hillocks on the underlying region, which inherits distortions from the template layer 160. Growth in the higher growth rates can improve the disturbed step-flow structure that has been formed in the growth of the lower growth rates. This improvement can reduce the compositional non-uniformity of constituent elements of the n-type 2nd semiconductor layer 167 (e.g., n-type AlGaN layer). The reduction of the compositional non-uniformity can provide, with a high compositional uniformity of constituent elements, a base on which the active layer 168 is grown.

Further, by way of example and not limitation, the growth rate of the n-type 1st semiconductor layer 165 may be 300 nm/h or more, and the growth rate of the n-type 2nd semiconductor layer 167 may 800 nm/h or less.

The present fabrication process provides, by way of example and not limitation, the following NH₃ partial pressures for the third condition. The NH₃ partial pressure of the n-type 1st semiconductor layer 165 may be 10 kPa or more, and the NH₃ partial pressure of the n-type 2nd semiconductor layer 167 may be less than 10 kPa.

Growth in higher NH₃ partial pressures is less likely to produce hillocks on the underlying region, which inherits distortions from the template layers 160. Growth in the lower NH₃ partial pressures can improve the disturbed step-flow structure that has been formed in the growth at the higher NH₃ partial pressures. This improvement can reduce the in-plane compositional non-uniformity of constituent elements of the n-type 2nd semiconductor layer (e.g., n-type AlGaN layer). The reduction of the compositional non-uniformity can provide, with a high compositional uniformity of constituent elements, a base on which the active layer 168 grows.

Further, by way of example and not limitation, the NH₃ partial pressures for growing the n-type 1st semiconductor layer 165 may be 12.5 kPa or lower, and the NH₃ partial pressures for growing the n-type 2nd semiconductor layer 167 may be 7.5 kPa or higher.

This fabrication process allows the n-type 2nd semiconductor layer 167, which is thin in thickness, to be grown on the n-type 1st semiconductor layer 165 so as to have a surface roughness which is equal to or less than the c-axis lattice constant thereof. In contrast, the first n-type 1st semiconductor layer 165, which is thick in thickness, is grown prior to the growth of the n-type 2nd semiconductor layer 167 so as to avoid increase in the surface roughness by suppressing the production of hillocks from screw dislocations of the template layer 160, and the suppression lowers the production of new dislocations. Specifically, the n-type 2nd semiconductor layer 167 has a surface roughness of 0.4 nm or less, while the n-type 1st semiconductor layer 165 has a surface roughness of 0.5 nm or less.

Forming the nitride semiconductor region 166 combines the growth process of the thick n-type 1st semiconductor layer 165 with that of the thin n-type 2nd semiconductor layer 167. This combination makes it easy to form linear steps during the growth of AlGaN of the n-type 2nd semiconductor layer 167, which is formed on the template layer 160. This reduces the generation of non-luminous centers produced from step wandering in the active layer 168.

By way of illustration and not limitation, the n-type 2nd semiconductor layer 167 may be provided with a thickness greater than that of the n-type 1st semiconductor layer 165.

The n-type 1st semiconductor layer 165 may be anAlGaN layer of an Al molar fraction of 0.7 or more, and the n-type 2nd semiconductor layer 167 may be an AlGaN layer of an Al molar fraction of 0.7 or more.

In the fabrication process, these Al molar fraction ranges can facilitate forming linear steps in growing AlGaN of the n-type 2nd semiconductor layer 167 on the template layer 160 to reduce the density of non-luminous centers, which are produced due to step wandering.

In this manufacturing method, growing the n-type 1st semiconductor layer 165 by using the at least one of the first to third conditions, as already described, can reduce the production of hillocks to prevent the growth steps from wandering. Accordingly, the n-type 2nd semiconductor layer can be provided with an excellent surface morphology, and the active layer 168 can be provided with a low dislocation density and compressive strain from the template layer 160. The active layer 168 may include the compressive stain, which depends upon Al_{X}Ga_{1-X}N template layer 160. Further, in the formation of a laminate from the template layer 160 to the nitride semiconductor region 166, the n-type 2nd semiconductor layer 167 is grown to have a thickness smaller than that of the n-type 1st semiconductor layer 165. When the thickness of n-type 1st semiconductor layer 165 is made greater than that of the n-type 2nd semiconductor layer 167, the n-type 2nd semiconductor layer 167 can be provided with a low surface roughness RMS and a low density of dislocations, which are derived from the template layer 160.

In this embodiment, the flow rates of organometallic aluminum precursors are not changed in switching from the growth of the n-type 1st semiconductor layer 165 to the n-type 2nd semiconductor layer 167. When necessary, the flow rates of the organometallic aluminum precursors can be changed at the switching.

By way of example and not limitation, reducing the flow rates of metalorganic aluminum precursors at the switching may result in growing the n-type 2nd semiconductor layers 167 having a smaller Al molar fraction than that of the n-type 1 st semiconductor layers 165. In this fabrication process, the nitride semiconductor region 166 may comprise the two n-type III nitride semiconductor layers 165 and 167 (e.g., n-type AlGaN layers), which have the first and second Al molar fractions different from each other, respectively. The nitride semiconductor region 166 in which the first Al molar fraction is greater than the second Al molar fraction and the thickness of the n-type 2nd semiconductor layer is smaller than that of the n-type 1st semiconductor layer can provide the n-type 2nd semiconductor layer 167 with an excellent surface morphology, and a low density of dislocations from the template layer 160. Growing the n-type 1st semiconductor layer 165, which has a relatively higher Al molar fraction, using at least one of the first to third conditions can prevent the growth steps from wandering, and reduce the generation of hillocks to provide the active layer 168 with a low density of non-luminous-centers, and a low density of dislocations and the compressive strain originated from the template layer 160. Consequently, the compressive distortion of the active layer 168 are associated with that of the template layer 160 of Al_{X}Ga_{1-X}N.

As already described, the active layer 168 may have a quantum well structure. The quantum well structure of the active layer 168 includes one or more well layers and one or more barrier layers. The bandgap of AlGaN of the compressively-strained well-layers is smaller than that of AlGaN of the compressively-strained barrier layers, so that each well layer contains compressive strain, and each barrier layer contains compressive strain.

In this fabrication process, the Al_{X}Ga_{1-X}N template layer 160 applies compressive strain to the quantum-well structure of the active layer 168 through the nitride semiconductor region (for example, the semiconductor region for the lower III nitride laminate 113) of a lower lattice relaxation rate. The compressive strain thus applied can reduce the absolute value of the internal electric field in the quantum well structure, thereby weakening the quantum confinement Stark effect therein. This weakening promotes the delocalization of the electron wave function in the well layers, which can increase the recombination probability (the overlap integral of the wave functions of hole and electron).

Further, applying the compressive strain to the quantum well structure, which is disposed on the lower III nitride laminate 113 of a low lattice relaxation rate in the nitride semiconductor region, can reduce the polarization difference between the barrier and well layers.

The lower surface roughness RMS of the nitride semiconductor region 166 can provide AlGaN of the well layers of the active layer 168 with a compressive strain of 1.5% or more. Deterioration of the flatness of the n-type 2nd semiconductor layer 167 would prevent the strain of the template layer from being effectively applied to the active layer 168. In other words, in order to achieve 1.5% or more compressive strain in the active layer 168, the underlying n-type 2nd semiconductor layer 167 needs to provide the active layer 168 with a highly planar surface.

The compressively-strained active layer 168 and the nitride semiconductor region 166 of the low surface roughness RMS can provide such a light-emitting device with an emission spectrum of a full width at half maximum of 10 nm or smaller.

By way of illustration and not limitation, the thickness of the n-type 1st semiconductor layer 165 may be 200 nm or more, and the thickness of the n-type 2nd semiconductor layer 167 may be 200 nm or less. The nitride semiconductor region 166 provides a low density of dislocations and an excellent planarity, which are derived from the template layer 160, with the growth of the active layer 168.

In this embodiment, one or more III nitride semiconductor layers are grown prior to growing the nitride semiconductor regions 166 and the active layer 168.

Specifically, Al_{U}Ga_{1-U}N layer 170 (U is less than or equal to X and greater than zero) may be grown to cover the template layer 160. The Al_{U}Ga_{1-U}N layer 170, which has an Al molar fraction greater than that of the nitride semiconductor region 166.

The Al_{U}Ga_{1-U}N layers 170 may be, for example, undoped. The density of spiral dislocations of the Al_{U}Ga_{1-U}N layer 170 is, for example, 4×10⁶ cm⁻² or less, and the density of threading dislocations of AluGai-uN layer 170 is, for example, 9×10⁸ cm⁻² or less. The Al_{U}Ga_{1-U}N layers 170 may be compressively strained. When the template layer 160 is AlN, the relaxation rate of the AluGai-uN layer to this AlN is less than 2%. In this process, the Al_{U}Ga_{1-U}N layer 170 may inherit, from the template layer 160, a density of threading dislocations and compressive distortion.

Specifically, another Al_{V}Ga_{1-V}N layer 172 (V is less than 1 and greater than 0.8; V is less than U) may be grown on the Al_{U}Ga_{1-U}N layer 170. The Al molar fraction of the Al_{V}Ga_{1-V}N layer 172 is greater than that of the nitride semiconductor regions 166.

The Al_{V}Ga_{1-V}N layers 172 may be, for example, undoped. The Al_{V}Ga_{1-V}N layer 172 has, for example, a spiral dislocation density of 4×10⁶ cm⁻² or less. The Al_{V}Ga_{1-V}N layer 172 may be compressively strained. In this fabrication process, the Al_{V}Ga_{1-V}N layer 172 may have an Al malar fraction which is lowered therefrom toward the active layer 168, while inheriting the threading dislocation density of the template layer 160. When the template layer 160 is made of AlN, the lattice relaxation rate of the undoped AlvGai-vN layer to AlN is not more than 2%.

The III nitride semiconductor laminate 164 may further be provided with the undoped Al_{U}Ga_{1-U}N layer 170 and undoped Al_{V}Ga_{1-V}N layer 172, in addition to the nitride semiconductor region 166 and the active layer 168.

In this embodiments, the multiple III nitride semiconductor layers, which are to be stacked on the top of the template layer 160, may be grown coherently with reference to the template layer 160, where the term "grown coherently" indicates a mode in which crystal continues to grow while the lattice constant being kept constant.

Subsequently, the multiple III nitride semiconductor layers (174, 176, and 178) in the III nitride laminate 164 are grown on the active layer 168. Specifically, the III nitride laminate 164 may include an electron block layer 174, a p-type compositionally-graded layer 176, and a p-type contact layer 178. The electron block layer 174, p-type compositionally-graded layer 176 and p-type contact layer 178 can be grown on the active layer 168 in this order.

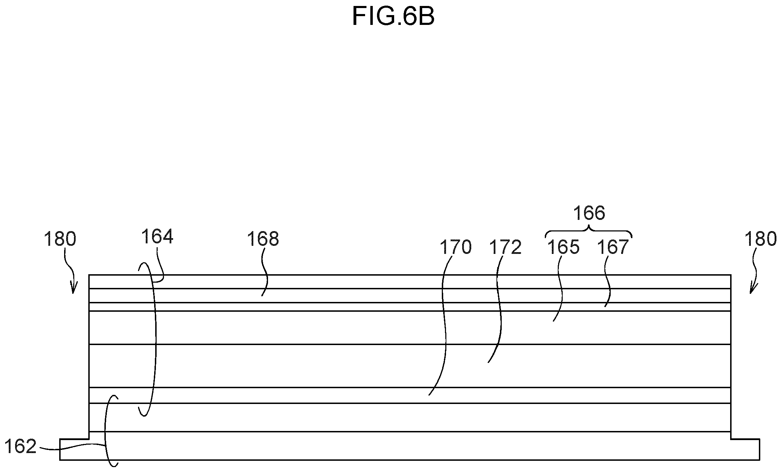

In the process of FIG. 6B, a trench 180 defining an outer edge of the device, i.e., the light emitting device, is formed by photolithography and etching. Etching is performed from the top face of the III nitride laminate 164 to the substrate 150 to form the trench 180.

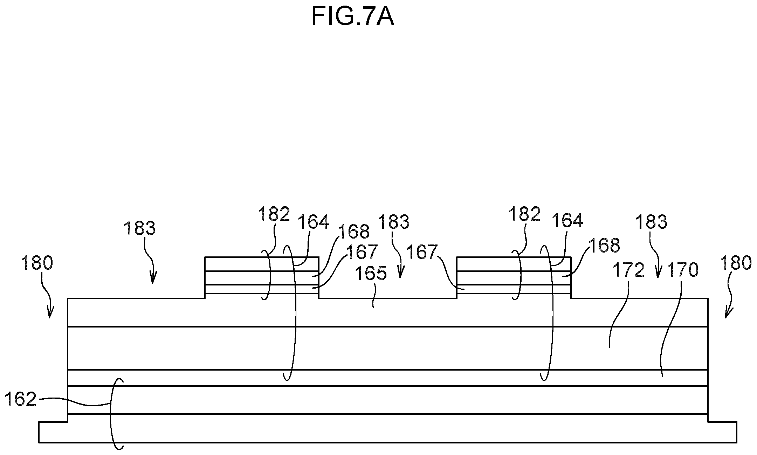

In the process of FIG. 7A, a region 182, which has been processed by etching, is formed by photolithography and etching. Etching is performed so as to form a trench 183 which reaches the n-type 2nd semiconductor layer 167 or n-type 1st semiconductor layer 165 (in this example, the n-type 1st semiconductor layer 165) from the upper face of the III nitride laminate 164 so as to separate the active layer 168. The etching does not reach Al_{V}Ga_{1-V}N layers 172.

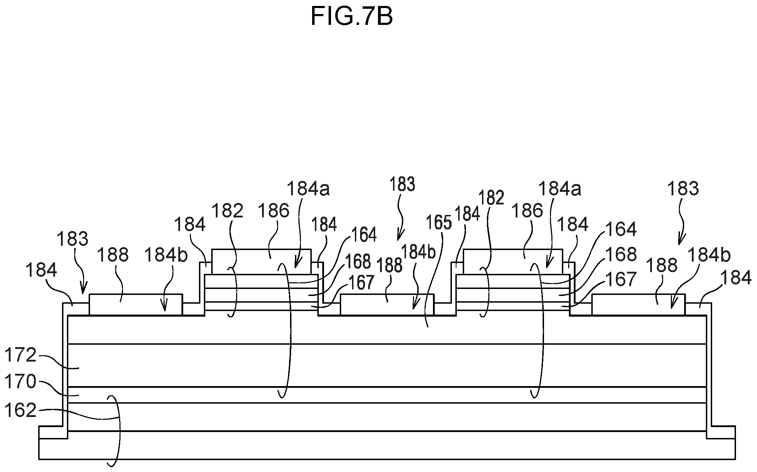

In the process of FIG. 7B, a passivation film 184, a p-side electrode 186, and an n-side electrode 188 are formed. The passivation film 184 has a first opening 184a located on the top face of the processed region 182 and a second opening 184b located on the bottom face of the trench 183, which defines the processed region 182.

Then, one of the p-side and n-side electrodes 186 and 188, in particular, the p-side electrode 186 is formed in the first opening 184a, while the other of the p-side and n-side electrodes 186 and 188, in particular, the n-side electrode 188 is formed in the second opening 184b.

These steps complete the light emitting device.

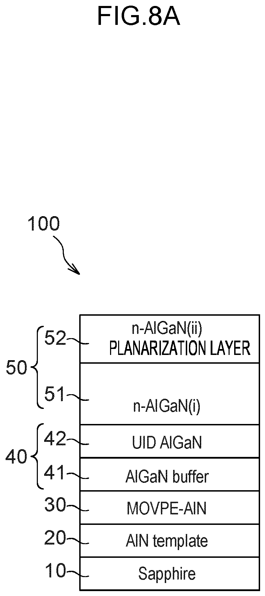

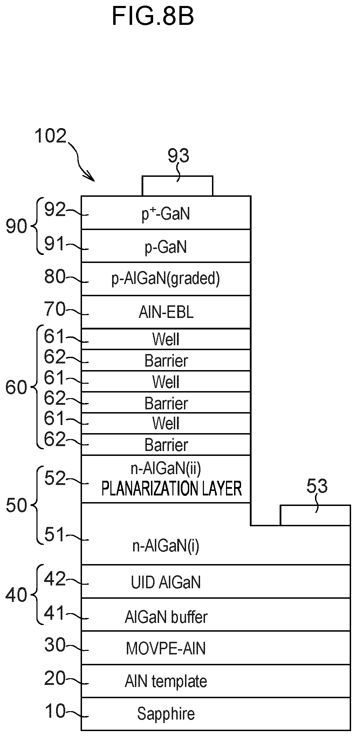

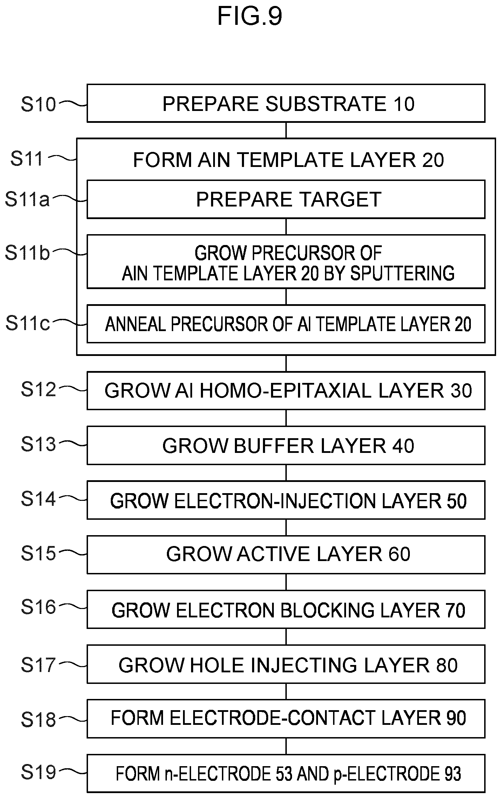

Exemplary light emitting devices will now be described as certain embodiments thereof. Referring to FIGs. 8A and 8B, a nitride semiconductor substrate 100 and a light-emitting diode according to a certain embodiment will be described. FIG. 8A is a schematic diagram of a laminate structure of a nitride semiconductor substrate 100. FIG. 8B is a diagram schematically illustrating a laminate of a light emitting diode 102 according to the embodiment. FIG. 9 is a flowchart showing major processes in the method of making a nitride light-emitting device according to the present embodiment, and the method of making an epitaxial wafer.

The nitride semiconductor substrate 100 has a substrate 10, an AlN template layer 20, an AlN homo-epitaxial layer 30, a buffer layer 40, and an electron injection layer 50. The light-emitting diode 102 is provided with the substrate 10, the AlN template layer 20, the AlN homo-epitaxial layer 30, the buffer layer 40, the electron injection layer 50, an active layer 60, an electron blocking layer 70, a hole injection layer 80, and a contact layer 90, which are sequentially stacked to form a laminate. The electron injection layer 50 is connected to an n-side electrode 53, and a p-side electrode 93 is connected to the contact layer 90.

Subsequently, each layer of the nitride semiconductor substrate 100 according to the embodiment will be described below.

In the process S10, the substrate 10 is prepared. The substrate 10 may be, for example, a sapphire substrate. However, the substrate 10 is not limited to sapphire and may include at least one of the following materials: carbon; boron nitride (BN); ceramics; silicon carbide; refractory metals; zirconia; tantalum carbide (TaC); and ScAlMgO₄. Further, in the sapphire substrate 10, the top sapphire face thereof may be a face slightly inclined from the (0001)-face of the sapphire (hereinafter referred to as "c-face"). This tilt may be in the range of, for example, 0.1 to 0.5 degrees from the c-face of sapphire, and more preferably in the range of 0.15 to 0.25 degrees with reference to the c-face of sapphire. The angle between the c-face and the top face of the substrate, that is, the inclination angle, is referred to as off angle.

In the process S11, the AlN template 20 is produced. The AlN template layer 20 essentially consist of AlN. The AlN template layer 20 is formed in order to grow epitaxial layers with excellent crystallinity on the substrate 10. In an embodiment, AlN of the template layer provides the following benefits. The lattice constant of AlN can be well matched to that of AlGaN utilized in the active layer 60 of ultraviolet light emitting diodes (DU-LED). Further, AlN on the sapphire substrate exhibits a higher optical transmittance in wavelengths of ultraviolet light. AlN exhibits a high thermal conductivity. These advantages are suitable when used as a template layer. AlGaN in which Al atoms of host AlN are slightly substituted with Ga atoms also exhibit similar properties.

In the process S11a, a sputtering target of desired material is prepared. In the process S 1 1b, precursors, for example, for the AlN template layer 20 are deposited by a sputtering method. In the process S11c, the deposited precursors are heat treated. Specifically, the precursors are deposited one or more times for AlN template layer 20, e.g., by a reactive sputtering method, on the top face of the substrate 10, and the substrate 10 and the deposited AlN thereon are applied to one or more heat treatments. This process forms the template layer 20. Deposition and heat treatment can be performed alternately. The method of forming the template layer 20 is not limited to reactive sputtering, and it can be performed using an MOVPE, or hydride vapor deposition (Hydride Vapor Phase Epitaxy: HVPE) method.

Increasing the thickness of the template layer 20 reduces the density of threading dislocations of AlN of the template layer 20. This reduction can improve the internal quantum efficiency of the active layer 60, which is formed on the template layer 20. On the other hand, reducing the film thickness of the template layer 20 can reduce the occurrence of cracks in the template layer 20. This reduction improves the yield of the light emitting diodes 102 which use the template layer 20. Specifically, the thickness of the AlN template layer 20 may be, for example, in the range of 100 to 10000 nm, and more preferably in the range of 500 to 1500 nm. One or more processes of sputtering and heat treatment to form the layer in these film thickness ranges can provide the template layer 20 with a sufficiently low density of threading dislocations and, less occurrence rate of cracks.

Subsequently, the epitaxial layers for the light emitting diode are formed on the AlN template layer 20 of the substrate 10. This epi-structure can be formed using deposition, such as MOVPE, HVPE, and MBE methods. In this embodiment, all layers other than the AlN template layer 20 may be fabricated by MOVPE.

In the process S12, an AlN homo-epitaxial layer 30 is formed. Specifically, prior to forming the AlN homo-epitaxial layer 30 on the AlN template layer 20, the surface of the AlN template layer 20 is treated (for surface cleaning), if required, in an MOVPE reactor. This surface treatment may be a heat treatment for about 10 minutes in an atmosphere at a high temperature. The surface treatment may be performed in a mixed atmosphere of H₂ and NH₃, or in a mixed atmosphere of H₂, NH₃ and N₂. The processing temperature may be, for example, 1200 degrees Celsius or more, and more preferably 1300 degrees Celsius or more. This treatment is performed to remove oxides and organic substances on the surface of the AlN template layer 20 and to suppress the introduction of defects into each layer from the AlN homo-epitaxial layer 30 to the contact layer 90, which are grown on the AlN template layer 20. The pressures used may be, for example, 13 kPa.

### (AlN homo-epitaxial layer)

The homo-epitaxial layer 30 is made of the same material as the template layer 20. In this embodiment, the homo-epitaxial layer 30 is made of, for example, AlN. The homo-epitaxial layer 30 has a surface with a superior flatness to that of the AlN template layer 20. In addition, the homo-epitaxial layer 30 prevents residual impurities (e.g., carbon (C), oxygen (O), and silicon (Si)), which may be contained in the template layer 20, from passing through the homo-epitaxial layer 30 thereto. The thickness of the homo-epitaxial layer 30 may be, for example, in the range of 10 to 10000 nm, and more preferably in the range of 50 to 1000 nm. The film thickness of the AlN homo-epitaxial layer 30 may be, for example, 200 nm. The AlN homo-epitaxial layer 30 is formed in an exemplary condition, for example, H₂ as carrier gas, NH₃ and TMAl as raw material, a growth pressure of 13 kPa, a substrate temperature of 1300 degrees Celsius.

In the step S13, on the homo-epitaxial layer 30, the buffer layer 40, such as an AlGaN buffer layer, is formed. The buffer layer 40 may be made of a nitride (Al_{y1}Ga_{z1}In_{(1-z1-y1)}N, 0<y1≤1, 0≤z1<1, y1+z1≤1), which contains group III elements as constituent element. Specifically, the buffer layer 40 works to allow the lower layer, which has been formed prior to the buffer layer 40, to match with an upper layer, which will be formed after forming the buffer layer 40 thereon, in terms of lattice constant. The buffer layer 40 may be made of, for example, AlGaN or AlGaInN. In an exemplary case in which an AlGaN layer (e.g., the active layer 60) is disposed on an AlN region (e.g., the AlN template layer 20 and the AlN homo-epitaxial layer 30), a matching layer is disposed to obtain the lattice-matching between the AlN layer and the AlGaN layer, since the lattice constants inherent to AlN and AlGaN are different from each other. The buffer layer 40 may be provided with a structure in which the lattice constant of the buffer layer 40 varies continuously or discontinuously along the stacking direction. The buffer layer 40 may be undoped, i.e., without intentionally doped with impurity, or it may be doped with n-type dopant, such as, Si, Ge (germanium), Sn (tin), O (oxygen), S (sulfur), Se (selenium), and Te (tellurium), to impart n-type conductivity to the semiconductor.

If desired, the buffer layer 40 may include a first buffer layer 41 and a second buffer layer 42, the Al molar fractions of which are different from each other. The Al molar fraction of the first buffer layer 41 may be equal to or greater than that of the second buffer layer 42. The Al molar fraction of the second buffer layer 42 may be equal to that of the electron injection layer 50 described below.

The first buffer layer 41 includes an AlGaN, which is grown using, for example, a mixture of H₂ and N₂ as a carrier gas, and raw materials of TMGa and TMAl that are mixed, where Ga (gallium):Al (aluminum) = 30:70. The growth pressure is, for example, 20kPa. The first buffer layer 41 may be grown, for example, at a temperature of 1200 degrees Celsius or more, and more preferably at a temperature of 1300 degrees Celsius or more. The first buffer layer 41 has a film thickness of 250 nm and an Al molar fraction of 0.88, and is undoped to intentionally add no impurity thereto.

The second buffer layer 42 includes an AlGaN and is grown on the first buffer layer 41. The second buffer layer 42 is grown using, for example, a mixture of H₂ and N₂ as a carrier gas, the raw material of TMGa and TMAl mixed, where Ga (gallium):Al (aluminum) = 30:70. The growth pressure is, for example, 40kPa. The second buffer layer 42 has a film thickness of 30 nm and an Al molar fraction of 0.75, and is undoped to intentionally add no impurity thereto.

In the process S14, an electron injection layer 50 is formed on the buffer layer 40. Specifically, the electron injection layer 50 can be made of a nitride (Al_{y2}Ga_{z2}In_{(1-z2-y2)}N, 0<y2≤1, 0≤z2<1, y2+z2≤1), which contains group III elements as constituent element. The electron injection layer 50 can include, for example, at least either AlGaN or AlGaInN. The electron injection layer 50 can be doped with dopant, such as, Si, Ge (germanium), Sn (tin), O (oxygen), S (sulfur), Se (selenium), and Te (tellurium) to impart n-type conductivity to the semiconductor. Thus, the electron injection layer 50 provides a conduction path to the active layer 60 with electrons.

Providing the electron injection layer 50 with a high Al molar fraction can reduce the lattice mismatch rate between AlN (e.g., the AlN template layer 20 and AlN homo-epitaxial layer 30) and the III nitride (e.g., AlGaN) of the electron injection layer 50. This reduction can effectively suppress the generation of misfit dislocations associated with lattice relaxation. The high Al molar fraction of the electron injection layer 50 can also effectively reduce the size of hillocks, which are produced during its deposition, to improve the surface flatness of the electron injection layer 50. The electron injection layer 50 of a high Al molar fraction can include compressive strain from the template layer 20 and apply it to the active layer 60. This allows the improvement of properties of the LED, more specifically, the improvement in the inner quantum efficiency of LED and the narrowed emission spectrum.

The Al molar fraction of the electron injection layer 50 may range, for example, from 0.6 to 0.9, and more preferably from 0.7 to 0.8. This range of the Al molar fraction can avoid an unwanted conductivity which is provided by too high Al molar fraction of the electron injection layer 50. The thickness of the electron injection layer 50 may be, for example, within 200 to 3000 nm to give enough strain to the active layer 60.

The electron injection layer 50 may be formed of a first electron injection layer 51 and a second electron injection layer 52, which are grown in respective growth conditions. First, the second electron injection layer 52 is grown to have an excellent surface roughness for the active layer 60. For this purpose, a film formation condition is selected which allows the AlGaN to be grown so as not to wander the step terraces of the AlGaN. In contrast, the first electron injection layer 51 is grown so as to provide the electron injection layer 50 with a desired film thickness, while suppressing the generation of hillocks which are due to dislocations of the template layer 20, to maintain the area of high surface flatness as wide as possible. The deposition condition for the second electron injection layer 52 allows the semiconductor of the second electron injection layer 52 to be grown so as to improve the step terrace structure, in terms of its linearity, that has already formed on AlGaN face of the first electron injection layer 51. Specifically, this is to reduce the possibility that pit-like defects which have been formed during crystal growth of the first electron injection layer 51 are left at the face of the second electron injection layer 52, thereby reducing the surface roughness RMS of the second electron injection layers 52. The Al molar fraction of the first electron injection layer 51 may be equal to that of the second electron injection layer 52, and may be larger than that of the second electron injection layer 52. The thickness of the second electron injection layer 52 may be in a range of, for example, 10 to 200 nm, and more preferably 50 to 150 nm.

The first electron injection layer 51 is grown on the buffer layer 40 and doped with Si. The first electron injection layer 51 is grown using, for example, a mixture of H₂ and N₂ as carrier gas, the mixture of raw material, TMGa and TMAl, where Ga (gallium):Al (aluminum) = 30:70, a growth pressure of 40kPa, and a substrate temperature of 1150 degrees Celsius. In growing the first electron injection layer 51, at least one of the following conditions may be used which relate to the ranges of substrate temperatures, growth rates, and NH₃ partial pressures.
Condition in which the substrate temperature ranges from 1000 to 1200 degrees Celsius.
Condition in which the growth rate is 1000 nm/h or less, and more preferably, 400 nm/h
Condition in which the NH₃ partial pressure in the MOVPE reactor is 5 kPa or more, and more preferably 10 kPa or more.
Using at least one of these conditions can effectively reduce the size of the hillocks, and improve the surface flatness of the first electron injection layer 51. Specifically, the thickness of the first electron injection layer 51 is 1100 nm, the Al molar fraction thereof is 0.75, and the Si dopant concentration thereof is 2×10¹⁹ cm⁻³. The substrate temperature during the growth of the first electron injection layer 51 is 1150 degrees Celsius, and the growth rate is 400 nm/h, and the NH₃ partial pressure is 10 kPa.

The second electron injection layer 52 is grown on the first electron injection layer 51, and doped with Si. The second electron injection layer 52 is grown using, for example, a mixture of H₂ and N₂ as carrier gas, a growth pressure of 10 kPa, the mixture of raw material, TMGa and TMAl, where flow rate ratio is Ga (gallium):Al (aluminum) = 30:70, and a substrate temperature of 1050 degrees Celsius. In the growth of the second electron injection layer 52, at least one of the following ranges of substrate temperatures, growth rates, and NH₃ partial pressures may be used.
Conditions in which the substrate temperature of the second electron injection layer 52 is lower than that of the first electron injection layer 51
Condition in which the growth rate of the second electron injection layer 52 is greater than that of the first electron injection layer 51
Condition in which the NH₃ partial pressure of the second electronic injection layer 52 is lower than that of the first electronic injection layer 51
Using at least one of these conditions can improve, in the growth of the second electron injection layer 52, the step terrace structure that has been disturbed in the growth of the first electron injection layer 51, to provide a linear-like step terrace structure on the surface of the second electron injection layer 52, thereby reducing the pit-like defects that has been formed due to the disturbed step terrace structure. Further, when the thickness of the second electron injection layer 52 is made smaller than that of the first electron injection layer 51, the second electron injection layer 52 is provided with an excellent surface roughness RMS, which had been formed prior to growing the hillock structure to lower the surface flatness of AlGaN. The second electron injection layer 52 has, for example, a thickness of 100 nm, an Al molar fraction of 0.75, and a Si dopant concentration of 2×10¹⁹ cm⁻³.

In the process S15, the active layers 60 are formed. Specifically, the active layer 60 comprises a structure having AlGaN well layers 61 and AlGaN barrier layers 62 alternating arranged. The AlGaN well layers 61 and AlGaN barrier layers 62 comprise AlGaNs having respective Al molar fractions. Specifically, the Al molar fraction of the AlGaN well layers 61 is smaller than that of the AlGaN barrier layer 62. The thickness of the AlGaN well layer 61 may range from 0.5 to 3.0 nm, and more preferably 1.0 to 2.5 nm. The number of the AlGaN well layers 61 may be, for example, three. The topmost layer of the active layer 60 may be an AlGaN well layer 61 and may be in contact with the electron block layer 70 on the active layer 60. Further, the multiple AlGaN well layers 61 can be provided with the same film thickness and Al molar fraction, or can also be provided with a film thickness and an Al molar fraction which are different from each other. For example, the AlGaN well layer 61 as the uppermost layer of the active layer 60 is in contact with the electron block layer 70, and can be provided with a smaller film thickness as compared to the other AlGaN well layers 61. The emission wavelength of the active layer 60 may range from 220 to 285 nm, and more preferably 255 to 285 nm. The AlGaN well layers 61 each have a thickness of 2 nm, an Al molar fraction of 0.51, and a Si dopant concentration of 3×10¹⁷cm⁻³. Further, the AlGaN barrier layers 62 each have a thickness of 3 nm, an Al molar fraction of 0.66, and a Si dopant concentration of 5×10¹⁷cm⁻³.
Growth conditions of AlGaN of the active layer 60
Growth-pressure: 40kPa
Substrate temperature: 1050 degrees Celsius
An AlGaN barrier layer 62 may be in contact with the electron injection layer 50, or an AlGaN well layer 61 may be in contact with the electron injection layer 50.

In the process S16, the electron block layer 70 is formed on the active layer 60. Specifically, the electron block layer 70 can be made of a nitride (Al_{y3}Ga_{z3}In_{(1-z3-y3)}N, 0<y3≤1, 0≤z3<1, y3+z3≤1), which contains group III elements as constituent element. The electron block layers 70 may comprise, for example, at least one of AlN, AlGaN or AlGaInN, and may be, for example, undoped AlN. The band gap energy of the electron block layer 70 is greater than that of the AlGaN barrier layer 62. The electron block layer 70 prevents electrons, which flow from the electron injection layer 50, from leaking out of the active layer 60 to the hole injection layer 80. The thickness of the electron block layer 70 may range from 1 to 20 nm, more preferably from 3 to 10 nm, and may be, for example 5 nm. The electron block layer 70 may have a structure in which the band gap energy is continuously changed in the electron block layer 70 along the stacking direction. The electron block layer 70 may be undoped, i.e., without intentionally doping impurities, or may have a p-type conductivity imparted, for example, by being doped with p-type dopant, such as, Mg (magnesium), Be (beryllium), C (carbon), or Zn (zinc).
Growth conditions of AlN of the electron block layer 70
Growth pressure: 40kPa
Substrate temperature: 1050 degrees Celsius

In the process S17, the hole injection layer 80, such as a p-type AlGaN layer, is formed. Specifically, the hole injection layer 80 is disposed on the active layer 60 and the electron block layer 70. The hole injection layer 80 can be made of a nitride (Al_{y4}Ga_{z4}In_{(1-z4-y4)}N, 0≤y4≤1, 0≤z4≤1, y4+z4≤1), which contains group III elements as a constituent element. Specifically, the electron injection layer 50 can be made of at least one of AlN, AlGaN or AlGaInN. The hole injection layer 80 can have a p-type conductivity, which is imparted by being doped with p-type dopant, such as, Mg (magnesium), Be (beryllium), C (carbon), Zn (zinc). The hole injection layer 80 provides a conduction path of holes to the active layer 60. The band gap energy of the hole injection layer 80 is less than that of the electron blocking layer 70 and is greater than that of the contact layer 90, which is subsequently described. The hole injection layer 80 may have a structure in which the band gap energy changes continuously or discontinuously along the stacking direction from the active layer 60 to the electron blocking layer 70, specifically, a structure in which the band gap energy decreases. The thickness of the hole injecting layers 80 may range from 1 to 50 nm, and more preferably 5 to 20 nm.

In the process S18, the contact layer 90 is grown on the hole injection layer 80. Specifically, the contact layers 90 can be made of a nitride (Al_{y5}Ga_{z5}In_{(1-z5-y5)}N, 0≤y5≤1, 0≤z5≤1, y4+z4≤1), which contains group III elements as constituent element. The contact layers 90 can comprise, for example, one of GaN, AlGaN or AlGaInN. The contact layers 90 may have p-type conductivity imparted by adding p-type dopants, for example, Mg (magnesium), Be (beryllium), C (carbon), and Zn (zinc).

The contact layer 90 may include multiple GaN layers of respective dopant concentrations different from each other. In this embodiment, the contact layer 90 may include a first contact layer 91 and a second contact layer 92. The first contact layer 91 may be made of, for example, GaN containing Mg dopant in the range of 1×10¹⁸ to 5×10¹⁹ cm⁻³, which can form a high carrier conduction path. The second contact layer 92 may be made of, for example, GaN containing Mg dopant in the range of 5×10¹⁹ to 1×10²¹ cm⁻³ to make the contact-resistance between the semiconductor and the metal electrode low.

In the process S19, the n-side electrode 53 and the p-side electrode 93 are formed. Specifically, the n-side electrode 53 makes contact with the surface of the electron injection layer 50. The n-side electrode 53 may include at least one metal of Al, Ti (titanium), Ni (nickel), V (vanadium), Zr (zirconium), Mo (molybdenum), Ru (ruthenium), Rh (rhodium), Pd (palladium), Ag (silver), In, Sn (tin), Ta (tantalum), W (tungsten), Pt (platinum), and Au (gold). The n-side electrode 53 may be made of a metal formed by alloying these metals. The n-side electrode 53 may include a conductive oxide or a conductive nitride.

The p-side electrode 93 makes contact with the surface of the contact layer 90. The p-side electrode 93 may comprise at least one or more of Al, Ti, Ni, V, Zr, Mo, Ru, Rh, Pd, Ag, In, Sn, Ta, W, Pt, or Au. The p-side electrode 93 may be made of a metal formed by alloying these metals. The p-side electrode 93 may include a conductive oxide or a conductive nitride.

The following examples describe the morphology of the epi-face.

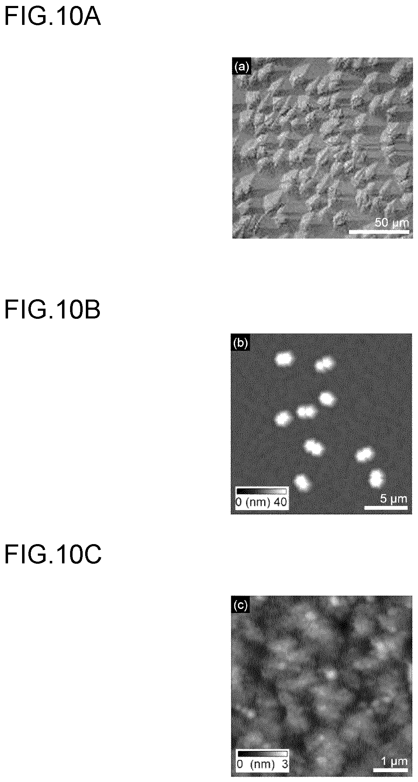

FIG. 10A is a diagram showing a differential interferometric microscopic image of the surface of the uppermost electron injection layer in the laminate that was grown on the template layer 20 (the film thickness of the buffer layer: 250 nm, and the film thickness of the electron injection layer: 1500 nm). In the surface of the electron injection layer, a hexagonal pyramid-like structure (called hillock structure) having a diameter of about 20 to 30 µm are shown over the entire surface, and thus the surface flatness is made low. This low surface flatness leads to the occurrence of lattice relaxation.

FIGs. 10B to 10F show atomic force microscopy images each showing the top face of the electron injection layer (the thickness of the buffer layer: 150 nm, and the thickness of electron injection layer: 150 nm) in the laminate that was grown on the AlN template layer 20. Specifically, referring to FIG. 10B, a similar hillock structure is also shown. The density of the hillocks is about 2×10⁶ cm⁻², which is comparable to the density of screw and mixed dislocations in the AlN templates 20. The hillock structure has a smaller size than that of the hillock structure in FIG. 10A. The difference in the size of the hillock structures results from the difference in the film thickness of the electron injection layers, and the FIG. 10B shows a smaller hillock structure in the electron injection layer of a small film thickness.

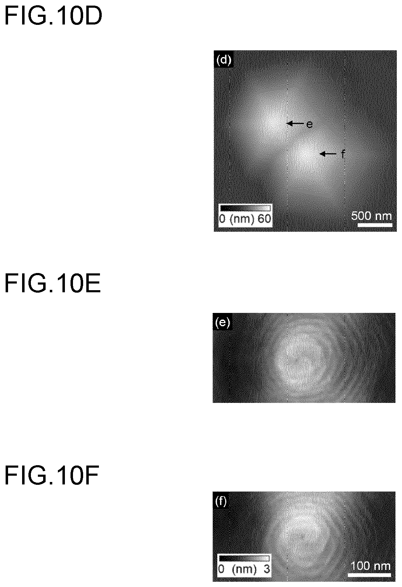

FIG. 10C is an enlarged view of the area where there is no hillock structure in FIG. 10B. Referring to Fig. 10C, there are no screw and mixed dislocations in the area shown. Referring to FIG. 10C, the steps, i.e., the difference of level, of about 0.25 nm, which is one-half of the c-axis lattice parameter of AlGaN, were formed at a high density on the AlGaN surface. These steps form an atomic step terrace structure. All of the atomic step terrace structures extend continuously (or forms loops) across the area shown. FIG. 10D is an enlarged view showing the hillock structure of FIG. 10B.

FIGs. 10E and 10F are enlarged views each showing the top portion of the hillock structure of the FIG. 10D. At the top portion of the hillock structure, the atomic step terrace structure forms a spiral-like shape to terminate at the center of the spiral, and such a growth is called spiral growth. The spiral structure indicates that screw or mixed dislocations are present at the top portion of the hillock structure. The density of hillocks on the surface of the electron injection layer is nearly equal to that of the screw and mixed dislocations of the AlN template layer 20 and is less dependent on the growth condition of the electron injection layer.

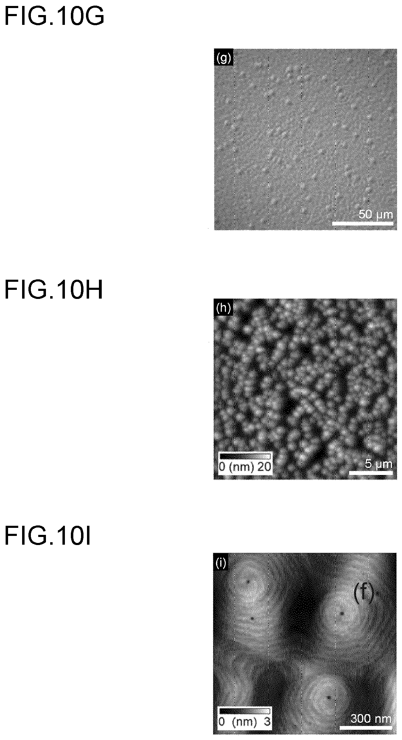

FIG. 10G shows a differential interferometric microscopic image of the top face of an electron injection layer (thickness of buffer layer: 250 nm, and thickness of electron injection layer: 1500 nm) in the laminate that was grown on the AlN template that was formed by MOVPE. Referring to FIG. 10G, a small hillock structure was densely formed, as compared to the morphology of FIG. 10A, to make the surface flatness thereof excellent.

FIGs. 10H and 10I show differential interferometric microscopy images each showing the surface of the electron injection layer (the thickness of the buffer layer: 150 nm, and the thickness of the electron injection layer: 150nm) in the laminate that was grown on the AlN template formed by MOVPE. Referring to FIG. 10H, a low density of hillock structures is shown.

FIG. 10I is an enlarged view of FIG. 10H. Referring to FIG. 10I, similar to FIGs. 10E and 10F, spiral growth occurred in the top portion of the hillock structure, so that a spiral-like structure was formed therein. In the structure of a high density of small hillocks, the atomic step terrace structure was also spirally formed from the high-density screw or mixed dislocations, as starting points, in growing AlGaN.

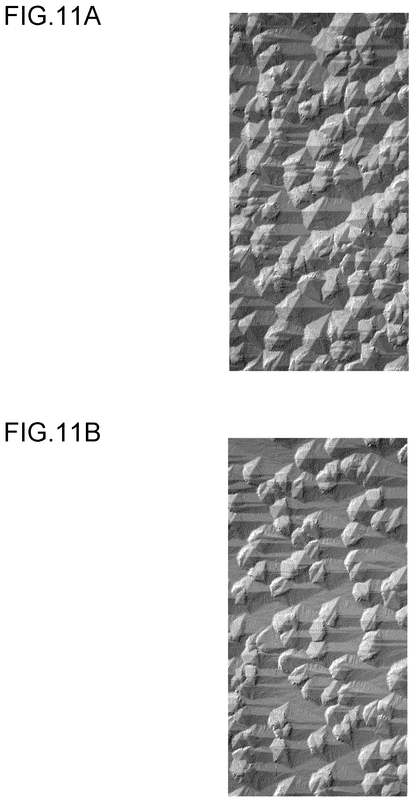

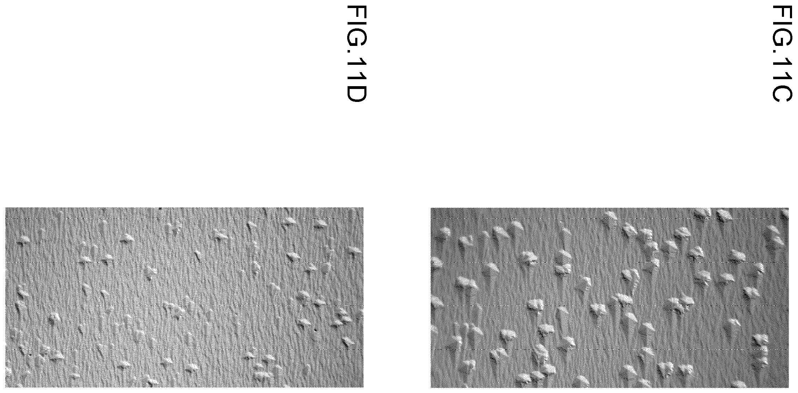

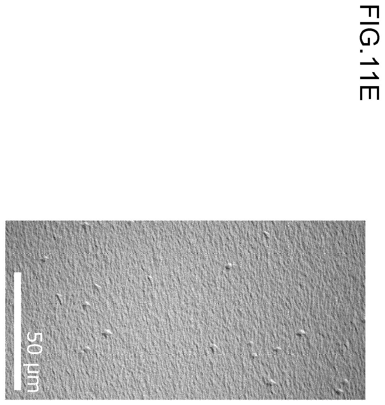

FIGs. 11A to 11E are images, taken by differential interferometric microscopy, showing the surface morphology of an epi-face (AlGaN film of a thickness of 1.5 µm and an Al molar fraction of 0.75). The growth parameters were follows: the growth temperature of 1150 degrees Celsius; the growth rate of 3.3 µm; and an NH₃ partial pressure of 1.0 kPa. Specifically, FIG. 11A shows a differential interferometric microscopy image of the electron injection layer 50 formed on the sapphire substrate of an off-angle of 0.2 degrees. FIG. 11B shows a differential interferometric microscopic image of an electron injection layer 50 formed on the sapphire substrate of an off-angle of 0.4 degrees. FIG. 11C shows a differential interferometric microscopic image of an electron injection layer 50 formed on the sapphire substrate of an off-angle of 0.6 degrees. Fig. 11D shows a differential interferometric microscopic image of an electron injection layer 50 of the sapphire substrate of an off-angle of 0.8 degrees. FIG. 11E shows a differential interferometric microscopic image of an electron injection layer 50 formed on the sapphire substrate of an off-angle of 1.0 degrees. Compared with FIGs. 11A to 11E, as the off-angle of the sapphire substrate increases, the size of the hillock structure of the electron injection layer 50 decreases.

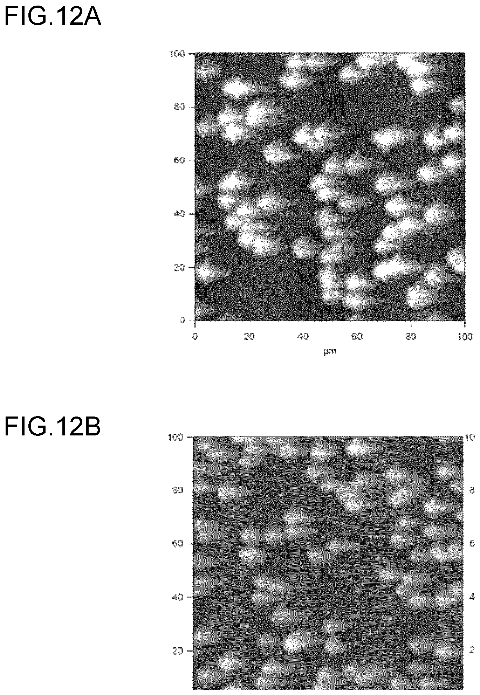

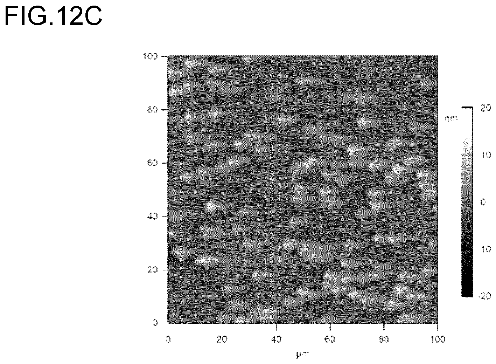

FIGs. 12A to 12C are views each showing the surface morphology of epi-face taken by atomic force microscopy. Specifically, FIG. 12A shows an atomic force microscopy image of the electron injection layer 50 grown at a substrate temperature of 1050 degrees Celsius. FIG. 12B shows an atomic force microscopy image of the electron injection layer 50 grown at a substrate temperature of 1100 degrees Celsius. FIG. 12C shows an atomic force microscopy image of an electron injection layer 50 grown at a substrate temperature of 1150 degrees Celsius. Compared with FIGs. 12A to 12C, when the growth temperature of the growth of the electron injection layer 50 becomes higher, the height and horizontal length of the hillock structure become smaller, i.e., the hillock structure size becomes smaller.

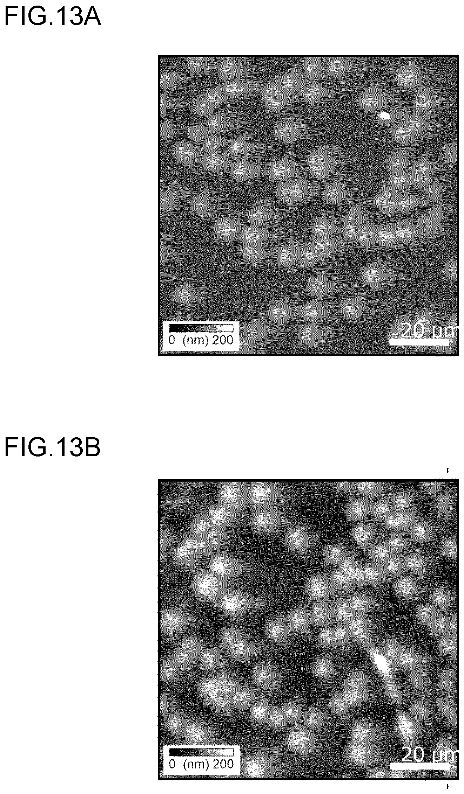

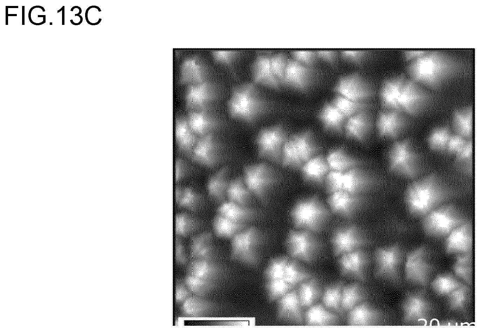

FIGs. 13A to 13C are views each showing the surface morphology of an epitaxial surface (the AlGaN film of a thickness of 1.0 µm and Al molar fraction of 0.75) taken by atomic force microscopy. The growth conditions were as follows: a growth temperature of 1150 degrees Celsius and an NH₃ partial pressure of 1.0 kPa. The epi-structure includes the buffer layer 40 of a thickness of 250 nm and the electron injection layer 50 of a thickness of 1500 nm. Specifically, FIG. 13A shows an atomic force microscopy image of the electron injection layer 50 grown at a growth rate of 500 nm/h. FIG. 13B shows an atomic force microscopy image of an electron injection layer 50 grown at a growth rate of 1200 nm/h. FIG. 13C shows an atomic force microscopy image of an electron injection layer 50 grown at a growth rate of 1500 nm/h. Compared with FIGs. 13A to 13C, when the growth rate in the growth of the electron injection layer 50 becomes slower, the height and horizontal length of the hillock structure becomes smaller, i.e., the size of the hillock structure becomes smaller.

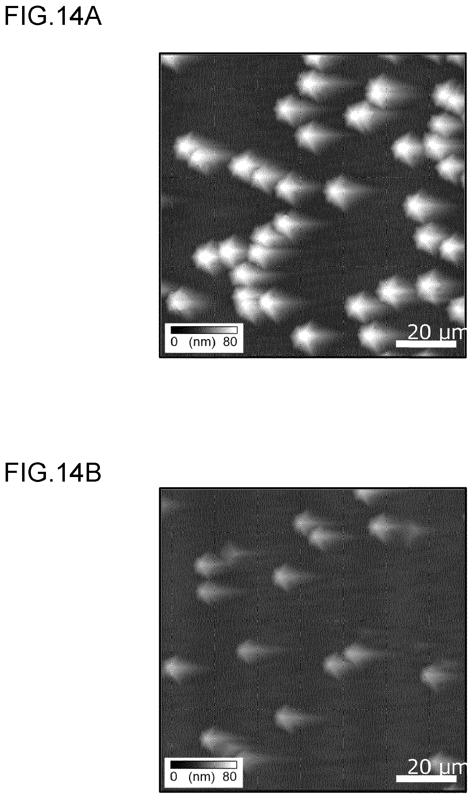

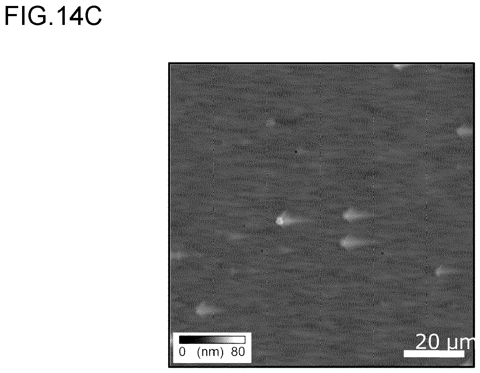

FIGs. 14A to 14C are views each showing the surface morphology of an epitaxial surface (the AlGaN film of a thickness of 1.0 µm and an Al molar fraction of 0.75) taken by atomic force microscopy. Specifically, FIG. 14A shows an atomic force microscopy image of the electron injection layer 50 grown at an NH₃ partial pressure of 1.0 kPa (hydrogen partial pressure of 18.9 kPa). FIG. 14B shows an atomic force microscopy image of the electron injection layer 50 grown at an NH₃ partial pressure of 4.0kPa (hydrogen partial pressure of 15.6 kPa). FIG. 14C shows an atomic force microscopy image of the electron injection layer 50 grown at an NH₃ partial pressure of 7.5 kPa (hydrogen partial pressure of 12.0 kPa). Compared with FIGs. 14A to 14C, when the NH₃ partial pressure in growing the electron injection layer 50 becomes higher, the height and horizontal length of the hillock structure becomes smaller, i.e., the size of the hillock structure becomes smaller.

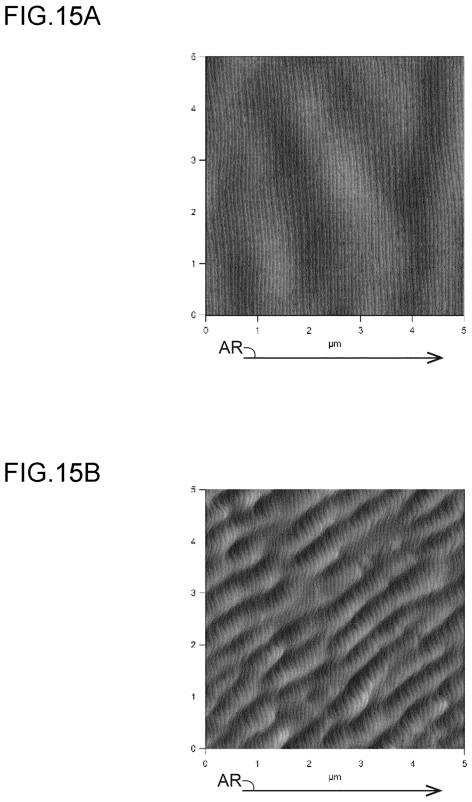

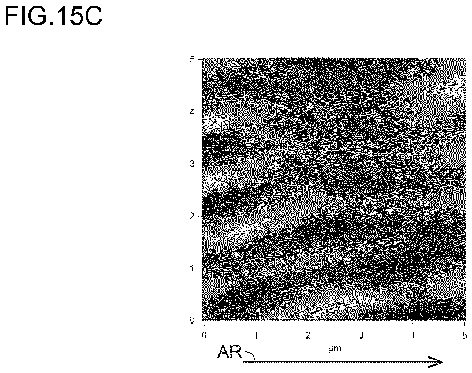

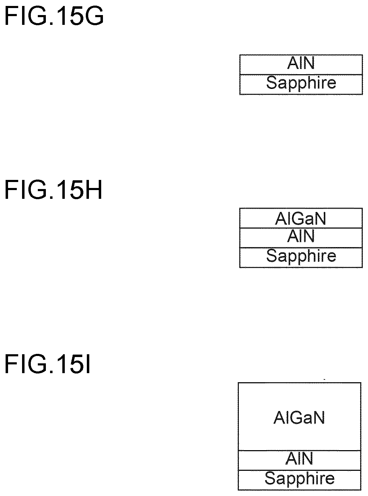

FIGs. 15A to 15C are views each showing the surface morphology of epi-surface taken by atomic force microscopy. Specifically, FIG. 15A shows an atomic force microscopy image of the AlN homo-epitaxial layer 30. FIG. 15B shows an atomic force microscopy image of the electron injection layer 50 (30 nm thick) grown on the AlN homo-epitaxial layer 30 without a buffer layer 40. FIG. 15C shows an atomic force microscopy image of the electron injection layer 50 (1000 nm thick) grown on the AlN homo-epitaxial layer 30 without a buffer layer 40. These observations were made to the areas that do not contain any of the screw and mixed dislocations.

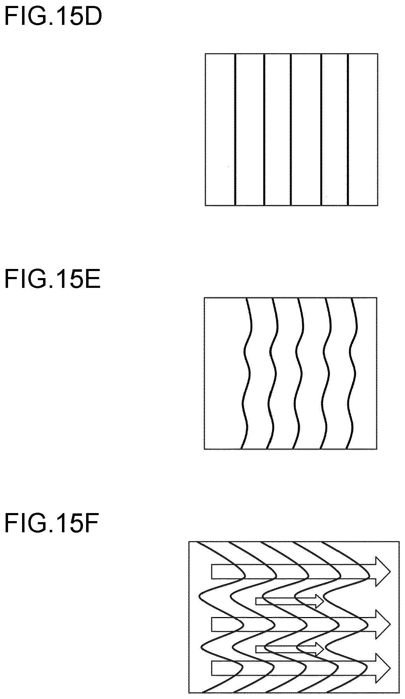

FIGs. 15D to 15F are views showing schematic patterns of atomic step terrace structures in atomic force microscopy images of FIGs. 15A to 15C, respectively. Arrows in the FIGs. 15A to 15C indicate the direction of the a-axis of the sample (the off-direction of the substrate surface). The magnitude of the long and short arrows in FIG. 15F represent the respective growth rates of the steps. FIGs. 15G to 15I show schematic patterns of the epitaxial structures of FIGs. 15A to 15C, respectively.

In both FIGs. 15A and 15C, the atomic step terraces are shown. FIG. 15A shows a regularly-aligned atomic step terrace structure, as depicted in the schematic patterns of FIG. 15D. FIGs. 15B and 15C show periodically-wandering atomic step terraces as depicted in the schematic patterns of FIGs. 15E and 15F. The wandering of the atomic steps worsens the surface morphology of the epi-structure.

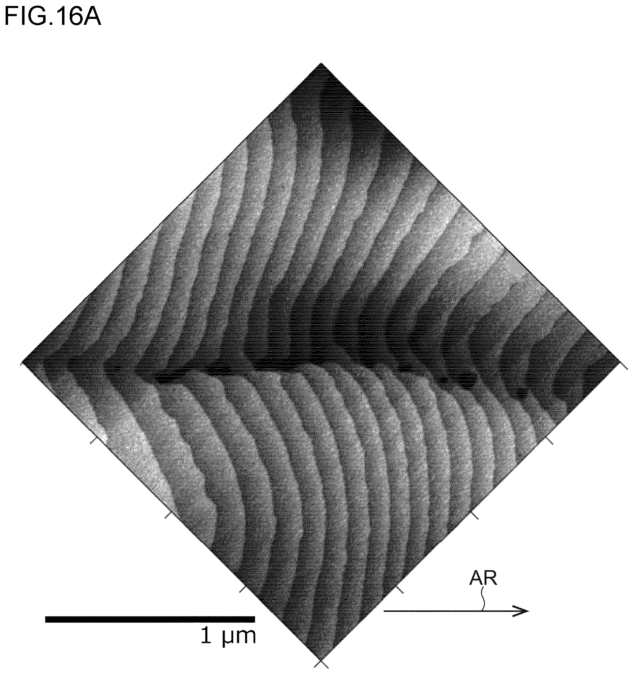

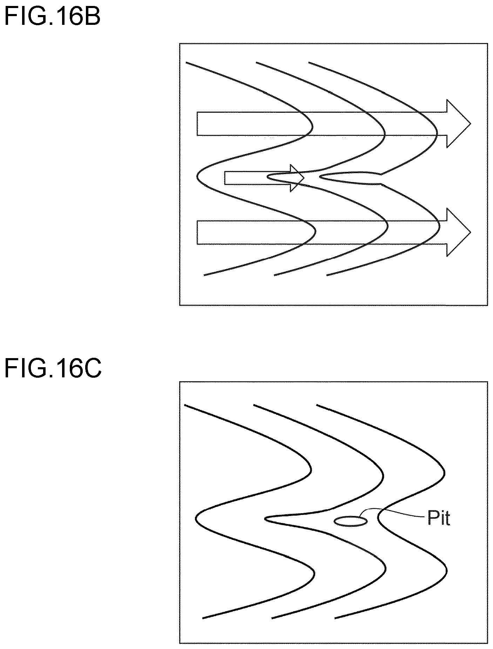

FIGs. 16A to 16C are views each showing the surface morphology of epi-face taken by atomic force microscopy. Specifically, the FIG. 16A shows an enlargement of the area of atomic-step wandering in the FIG. 15C. The arrow "AR" in Fig. 16A shows the a-axis direction of the epitaxial structure (the off-axis direction of the substrate face). Fig. 16B is a schematic diagram showing the growth rate of atomic steps. In Fig. 16B, the magnitude of the long and short arrows represent the respective growth rate of atomic steps. Fig. 16C shows a pattern of a pit "Pit", resulting from the wandering of atomic steps, in the atomic force microscopy image of Fig. 16A. The wandering of atomic steps is caused by the difference in the growth rate of the atomic step terrace structure. Specifically, a portion of the atomic step terrace structure grows slowly relative to the adjacent sides thereof that grow relatively fast, so that the slowly-grown portion is recessed in the atomic step terrace structure. The recess has a deep groove-like shape, which is a defect referred to as a pit Pit. The pits are formed in a conductive semiconductor path of the light-emitting device to cause non-luminous recombination of electrons and holes, thereby reducing the luminous efficiency of the light-emitting device. Furthermore, the pits of the electron injection layer 50 are inherited by the active layer 60 which is grown thereon. Accordingly, the wandering of the atomic step terrace structure and the resulting pit formation in the electron injection layer 50 may reduce the luminous efficiency of the light-emitting device that includes the electron injection layer 50.

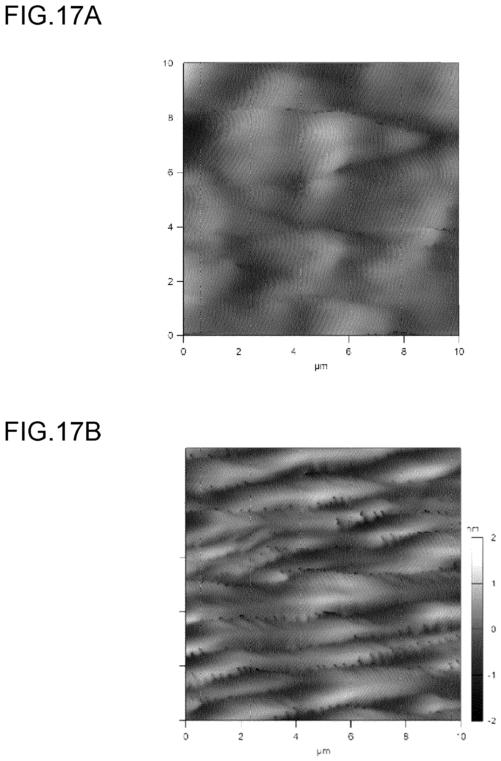

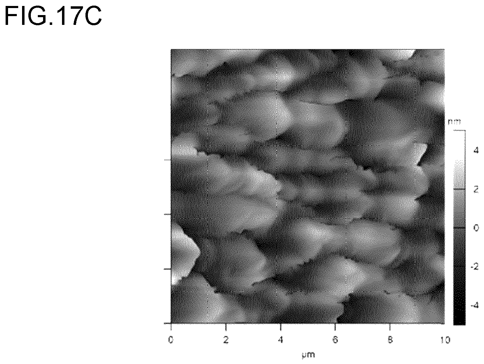

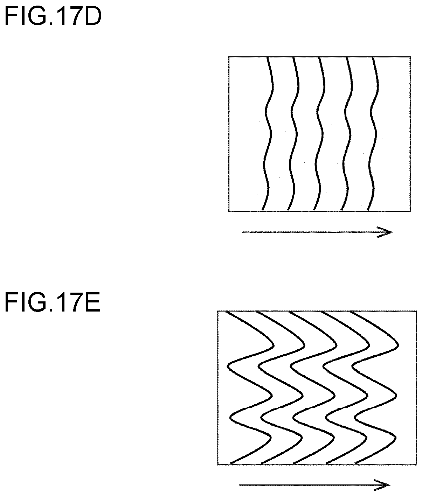

FIGs. 17A to 17C are views each showing the surface morphology of epi-face taken by atomic force microscopy. Specifically, FIG. 17A shows an atomic force microscopy image of an electron injection layer 50 of 1000 nm grown on a sapphire substrate with an off-angle of 0.1 degrees. FIG. 17B shows an atomic force microscopy image of the electron injection layer 50 of 1000 nm grown on a sapphire substrate with an off-angle of 0.2 degrees. FIG. 17C shows an atomic force microscopy image of an electron injection layer 50 of 1000 nm grown on a sapphire substrate with an off-angle of 0.3 degrees. FIGs. 17D and 17E show patterns of the surface morphology shown in FIGs. 17A and 17B, respectively. The surface morphology of the Fig. 17C shows step bunching.

Comparing the FIG.s 17A to 17C with each other, the sapphire substrates of small off-angles can improve the flatness of an area away from a hillock on the top face of the electron injection layer 50.

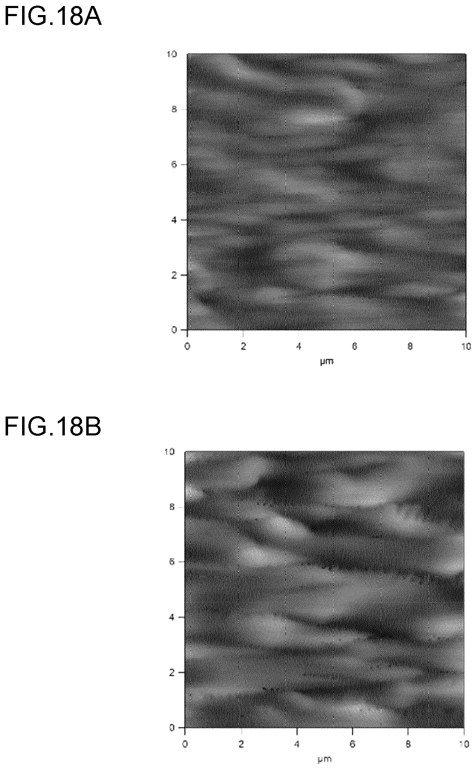

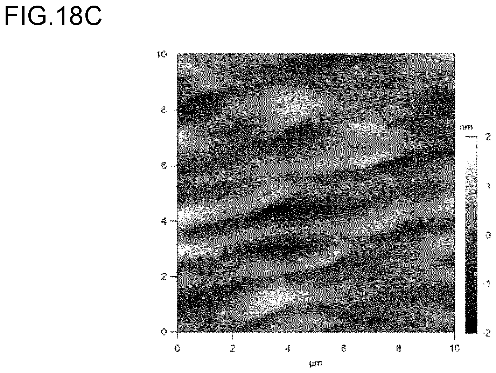

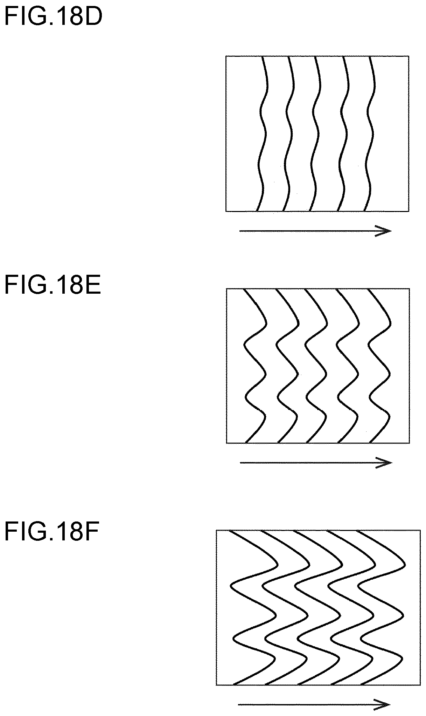

FIGs. 18A to 18C are views showing the surface morphology of epi-face taken by atomic force microscopy. Specifically, FIG. 18A shows an atomic force microscopy image of an electron injection layer 50 which is grown at a substrate temperature of 1050 degrees Celsius. Fig. 18B shows an atomic force microscopy image of an electron injection layer 50 grown at a substrate temperature of 1100 degrees Celsius. Fig. 18C shows an atomic force microscopy image of an electron injection layer 50 grown at a substrate temperature of 1150 degrees Celsius. FIG.s 18D to 18F are schematic views showing patterns of atomic step terrace structures in atomic force microscopy images of FIGs. 18A to 18C, respectively. Arrows in the FIGs. 18D to 18F each indicate the a-axis direction of the sample (the off-axis direction of the substrate surface).

When comparing FIGs. 18A to18C to each other, lowering the growth temperature in the growth of the electron injection layer 50 can suppress the surface roughness thereof which is caused by the wandering of the atomic step terrace structure. This results in that lowering the growth temperature of the electron injection layer 50 can improve the surface flatness of the area which is away from a hillock on the face of the electron injection layer 50.

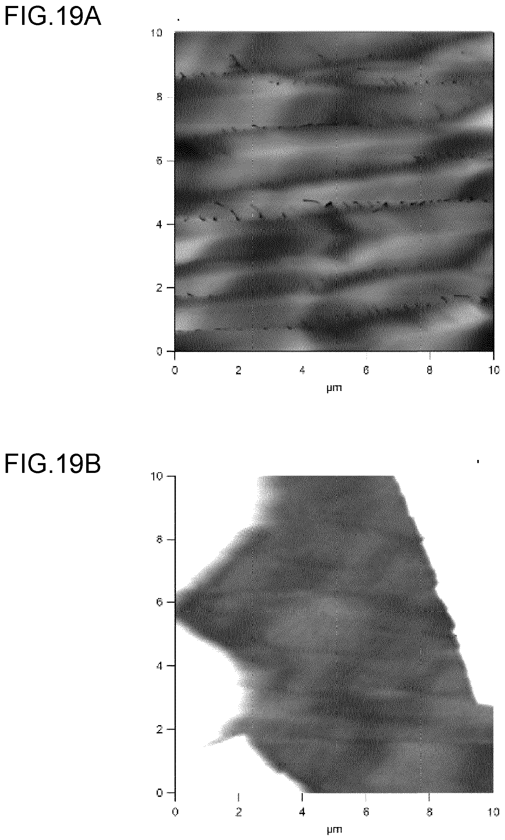

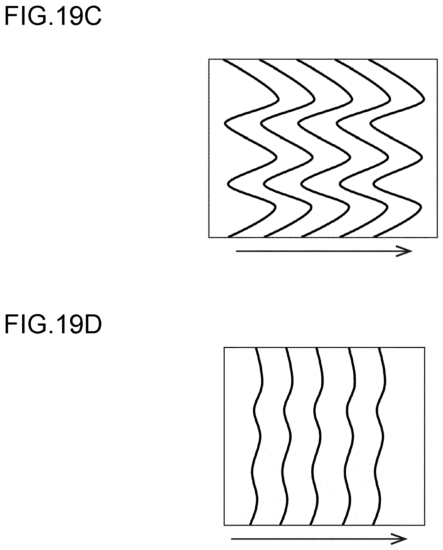

FIGs. 19A and 19B are views showing the surface morphology of epi-face taken by atomic force microscopy. The epi-structure is provided with a 250-nm thick buffer layer 40 and a 1500-nm thick electron injection layer 50. FIGs. 19C and 19D are schematic diagrams showing the patterns of atomic step-terrace structures in the atomic force microscopy images of FIGs. 19A and 19B, respectively. Arrows in FIGs. 19C and 19D each indicate the a-axis direction of the epi-substrate (the off-axis direction of the substrate surface). Specifically, FIG. 19A shows an atomic force microscopy image of the electron injection layer 50 grown at a growth rate of 400 nm/h. Fig. 19B shows an atomic force microscopy image of the electron injection layers 50 grown in the growth rate of 3500 nm/h.

Comparing the FIGs. 19A and 19B with each other, increasing the growth rate of the electron injection layer 50 can suppress the wandering of the atomic steps and the degradation of the surface roughness caused thereby. Increasing the growth rate in the growth of the electron injection layer 50 can improve the surface flatness of the area, which is away from a hillock, of the surface of the electron injection layer 50.

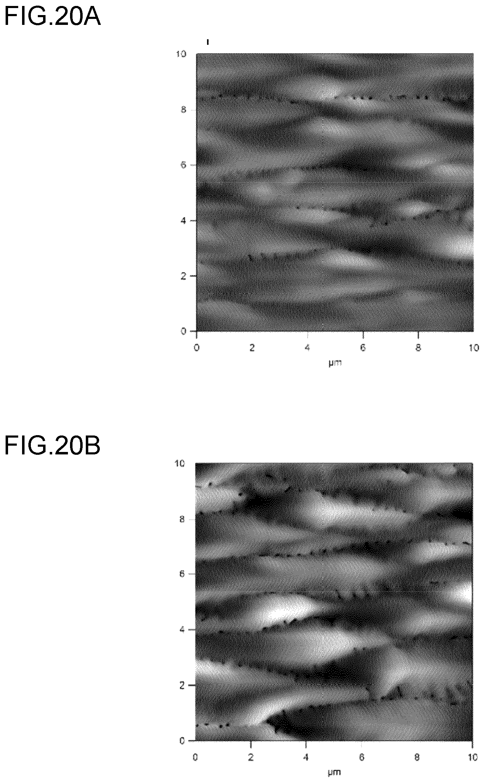

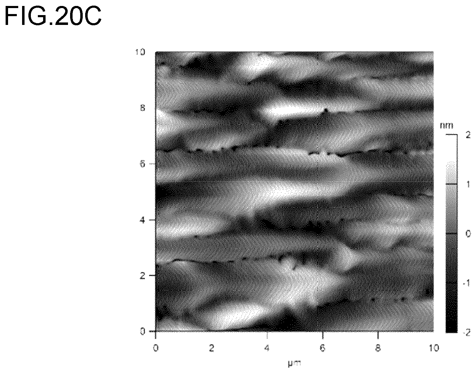

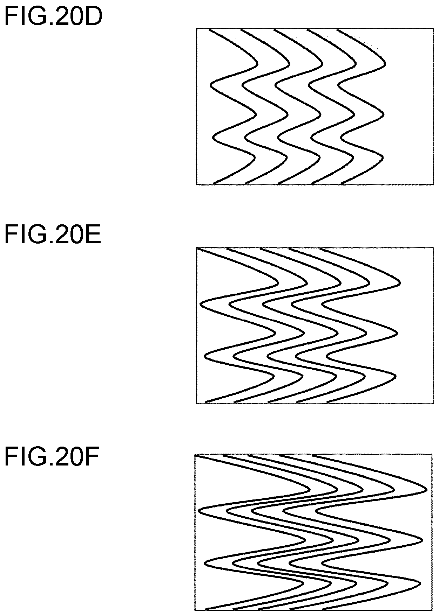

FIGs. 20A to 20C are views showing the surface morphology of epi-face taken by atomic force microscopy. Specifically, FIG. 20A shows an atomic force microscopy image of an electron injection layer 50 grown at an NH₃ partial pressure of 7.5 kPa (total pressure 30kPa). FIG. 20B shows an atomic force microscopy image of an electron injection layer 50 grown at an NH₃ partial pressure (total pressure 40 kPa) of 10.0 kPa. FIG. 20C shows an atomic force microscopy image of an electron injection layer 50 grown at an NH₃ partial pressure (total pressure 50 kPa) of 12.5 kPa. FIGs. 20D to 20F are schematic views showing patterns of atomic step terrace structures in atomic force microscopy images of FIGs. 20A to 20C, respectively.

Comparing FIG s. 20A to 20C to each other, decreasing the NH₃ partial pressure in growing the electron injection layer 50 can suppress the wandering of the atomic steps and the degradation of the surface roughness caused thereby. Reducing the NH₃ partial pressure in stacking the electron injection layer 50 can improve the surface flatness of the area, which is away from the hillock structure, of the surface of the electron injection layer 50.

### (Comparison of the surface flatness of two-step growth AlGaN and the MOVPE-AlN template)

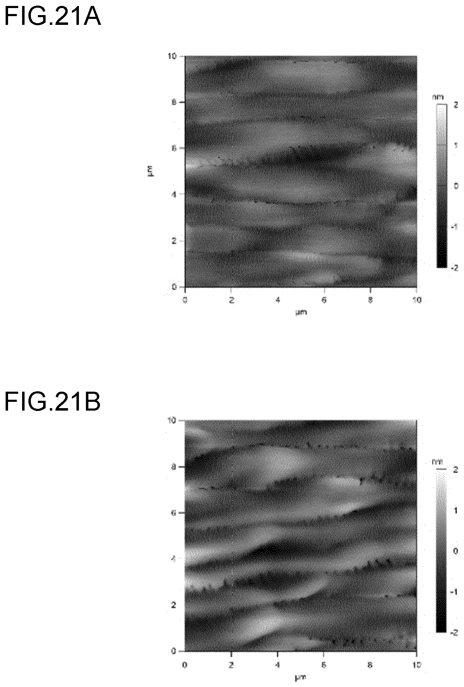

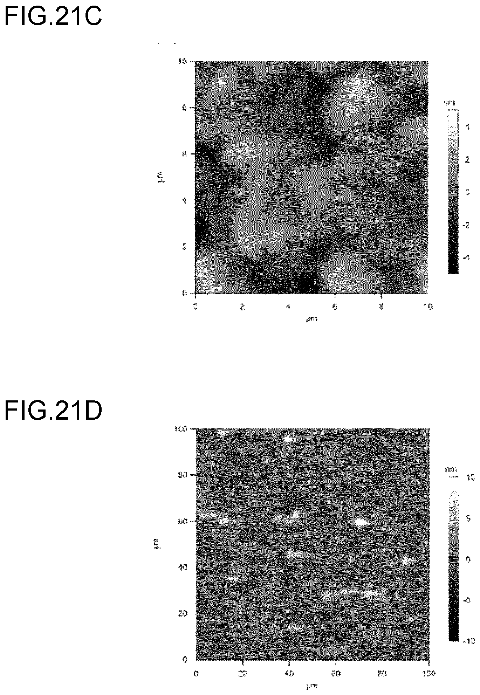

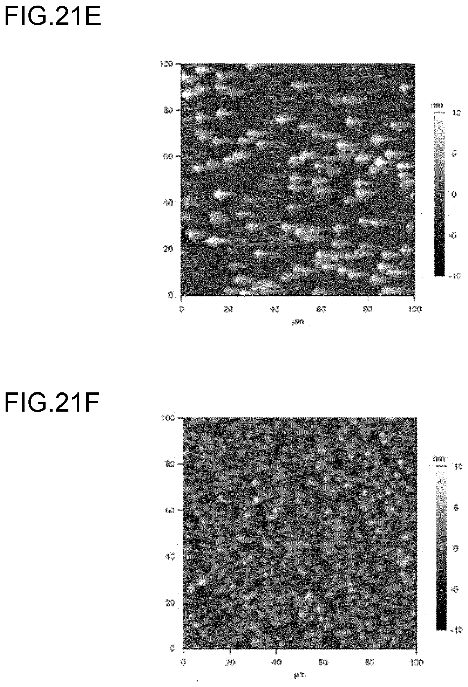

FIGs. 21A to 21F are drawings showing the surface morphology of epi-face taken by atomic force microscopy. Specifically, FIGs. 21A and 21D each show the surface of the electron injection layer 50 according to the embodiment, and the electron injection layer 50 includes the two layers of the first and second electron injection layers 51 and 52. The growth temperature and thickness of the first electron injection layer are 1150 degrees Celsius and 1000 nm, respectively, and the growth temperature and thickness of the second electron injection layer are 1050 degrees Celsius and 100 nm, respectively. FIGs. 21B and 21E each show the surface of a single electron injection layer grown at 1150 degrees Celsius. Figs. 21C and 21F each show, as a reference example, the top face of a single electron injection layer (referred to as "reference example") on an AlN template layer grown on a sapphire substrate by MOVPE. The single electron injection layer is formed at a growth temperature of 1150 degrees Celsius. The RMS values are 0.365 nm in FIG. 21A, 0.465 nm in FIG. 21B, and 1.145 nm in FIG. 21C.

Comparing FIGs. 21A and 21B with FIGs. 21D and 21E, respectively, in the electron injection layer 50 that has two layers of the first and second electron injection layers 51 and 52, the second electron injection layer is formed at a lower temperature than that of the first electron injection layer, so that the surface roughness, which is caused by the wandering of the atomic step terrace, is also reduced while suppressing an increase in the hillock size. That is, the surface flatness of the electron injection layer 50 is improved.

Comparing FIGs. 21A and 21B with FIGs. 21C and 21F, respectively, the surface roughness RMS of the electron injection layer 50 according to the embodiment is smaller than that of the single-layered electron injection layer according to the reference example. The AlN template layer 20 according to the embodiment has lower densities of helical dislocations and mixed dislocations, and thus spiral-growth is less likely to occur.

Regarding the surface morphology of the epi-structure according to the embodiment, the second electron injection layer 51 has a surface roughness RMS of 0.4 nm or less, which is estimated from the atomic force microscopy image.

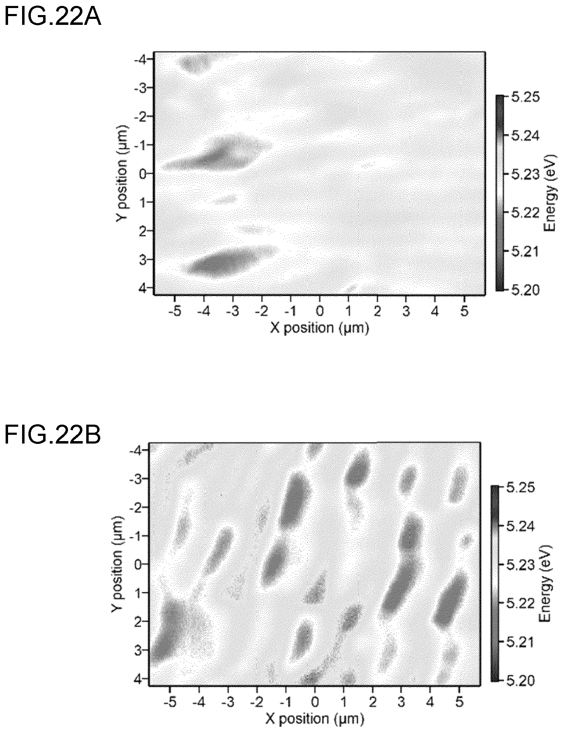

FIGs. 22A and 22B are views illustrating the peak energy distributions of the cathode luminescence (CL) of the surface of the electron injection layer 50 of the two-layer structure according to the embodiment, and the surface of the electron injection layer of the single-layer structure, respectively. Cathode luminescence provides an image from electrons emitted by exciting a vicinity of a semiconductor surface by electron beam. The measuring apparatus used was a CL system (MP-32S, Horiba, Ltd.), which was installed in a scanning electron microscope (JEM7100, manufactured by Nippon Electronics Co., Ltd.).

Specifically, FIG. 22A shows a CL mapping image, which was measured (at an electron beam acceleration voltage of 5kV), from the near surface of the two-layered electron injection layer 50 according to the embodiment (the first electron injection layer 51 with a film thickness of 500 nm, and the second electron injection layer 52 with a film thickness of 100 nm). FIG. 22B shows a CL mapping image, which was measured (at an electron beam acceleration voltage of 5kV), from the near surface of a single-layered electron injection layer (a film thickness of 600 nm). This acceleration energy allows CL emission to originate from the electron injection layer. The CL peak energy corresponds to the band gap energy of the target semiconductor, and the band gap energy of AlGaN corresponds to the Al molar fraction thereof. The peak energy of CL mapping corresponds to the Al molar fraction of the electron injection layer 50, and the region that exhibits a higher peak energy than that of the periphery thereof has a relatively high Al molar fraction, and the region that exhibits a lower peak energy than that of the periphery thereof has a relatively low Al molar fraction.

In FIG. 22A, the standard deviation is 2.57 meV, while in FIG. 22B, the standard deviation is 4.95 meV These show that in the two-layered electron injection layer 50, the fluctuation of the light emission energy spectrum in the order of several micrometers is suppressed, and the electron injection layer 50 is provided with an excellent uniformity of the Al molar fraction thereof as compared to the single-layered electron injection layer.

Since the surface morphology affects the incorporation efficiency of gallium atoms, low flatness results in compositional unevenness. The variation of the Al molar fraction can be estimated from that of the peak energy (standard deviation/average energy) of the cathode luminescence image. The variation of the Al molar fraction can be estimated to be 0.09% in FIG. 22A, and 0.16% in FIG. 22B. When the variation of the Al molar fraction is 0.1% or less in consideration of measurement error, a good surface flatness is obtained. Further, when the variation of the Al molar fraction is 0.09% or less, an excellent surface flatness is obtained.

Comparing FIG. 22A with FIG. 22B to each other, the two-layered electron injection layer 50 has a small standard-deviation of the peak energy. The small in-plane variation of the peak energy indicates that the electron injection layer 50 has a high in-plane uniformity in the Al molar fraction thereof. The small in-plane variation also indicates that the electron injection layer 50 according to the embodiment has a high surface flatness. Specifically, when the surface flatness of the electron injection layer is degraded to increase the roughness thereof, the density of the atomic step terraces is changed to create the condensation and rarefaction of the atomic step terraces at the surface of the electron injection layer. The region that has a higher density of atomic steps easily incorporates Ga raw material, which is supplied from the vapor phase during the crystal growth, to grow AlGaN of a relatively lower Al molar fraction. On the other hand, the region that has a lower density of the atomic step terraces easily releases Ga material, which has been supplied thereto from the vapor phase during the crystalline growth, to grow AlGaN with a relatively high Al molar fraction. The electron injection layer 50 of the two-layer structure is provided with a high surface flatness at the surface of the electron injection layer 50, which allows a high in-plane uniformity of the density of the atomic step terraces. The epi-structure according to the embodiment can improve the in-plane fluctuation of the Al molar fraction, which is associated with the fluctuation of the density of the atomic step terraces.

When an additional electron injection layer is deposited on the single-layered electron injection layer using a growth condition for forming the second layer of the electron injection layer 50 (i.e., the growth condition of the second electron injection layer 52, specifically, at least one of the first to third conditions), the surface of the additional electron injection layer is provided with a small energy deviation in the CL image. Specifically, growing the one or more additional electron injection layers using at least one of the first to third conditions can improve the in-plane uniformity of the density of the atomic step terraces, so that the surface roughness RMS is becoming smaller from the initial surface roughness as the additional electron injection layer continues to grow thereon. The improvement of the step-terrace linearity of the structure can reduce the energy deviation in the CL image at the surface of the additional electron injection layer, and the surface roughness RMS thereof. The in-plane distribution of III elements (e.g., Al atom) in the additional electron injection layer exhibits a higher uniformity than that of III elements (e.g., Al atoms) of the underlying electron injection layer (e.g., the electron injection layer of the single layer structure). Specifically, if CL images of the individual growing surfaces thereof could be observed during the deposition of the second layer, the energy deviations in the CL images would be becoming less than the energy deviation of the first layer (e.g., the energy deviation in the cathode luminescence image would be less than 4.95 meV). By way of example and not limitation, in the electron injection layer 50, an energy deviation in the CL image of the lower electron injection layer is, for example, 3.76 meV or more, and the energy deviation in the CL image of the upper electron injection layer is less than, for example, 3.76meV, due to the growth of the second layer. The value, 3.76meV, is the arithmetic average of 2.57meV and 4.95meV.

The CL image of the above-mentioned epi-face according to the embodiment shows that the second electron injection layer 51 has a variation of 0.1% or less in terms of the Al molar fraction.

When measuring CL images near the surface of the active layer (e.g., the active layer 114), which is grown continuously on the surface (the surface having the above-described qualities) of the two-layered electron injection layer 50, the standard-deviation of the emission peak in the CL image is 3.51meV. This value is greatly reduced as compared with 6.86meV, which is the standard-deviation of the emission spectrum estimated in the device formed by the single-layer growth. This indicates that the difference in the above values is large when compared to the compositional variation of the underling electron injection layer and that the surface roughness of the electron injection layer greatly affects the compositional uniformity of the active layer, which is composed of multiple layers having different compositions and film thicknesses from each other.

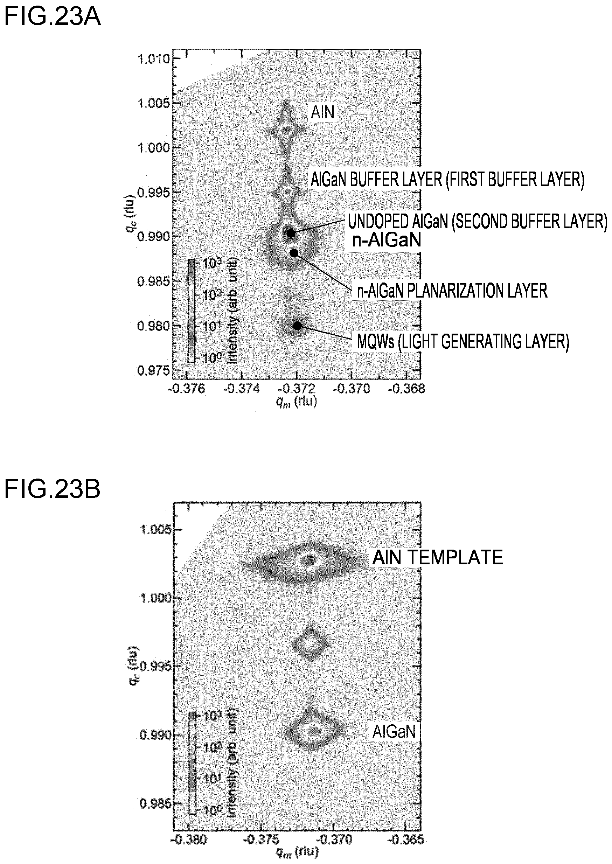

FIGs. 23A and 23B are drawings showing X-ray diffractometry (X-ray Diffraction: XRD) reciprocal space mapping (Reciplocal Space Mapping: RSM) images. Specifically, FIG. 23A shows a reciprocal lattice space mapping image of a nitride semiconductor epitaxial substrate comprising the template layer 20 and the two-layered electron injection layer 50 according to the embodiment. FIG. 23B shows the reciprocal space mapping image of a nitride semiconductor epitaxial substrate, as a reference example, including an MOVPE-AlN template and a single electron injection layer. In FIGs. 23A and 23B, the vertical axis of XRD-RSM images indicates "qc", the horizontal axis indicates "qm". The "qc" represents the reciprocal of the distance between the crystal planes perpendicular to the c-axis in the hexagonal system, the "qm" represents the reciprocal of the distance between the crystal planes perpendicular to the m-axis in the hexagonal system. The values of "qc" and "qm" at the individual signal peak attributed to each layer of the substrate correspond to the reciprocals of the lattice spacings of (0005) and (10-10) planes, respectively.

The following values were estimated from the XRD-RSM images according to the embodiment.

**(Table 1)**

| Layer name; | Al content; | a-axial lattice constant; | c-axial lattice constant; | In-plane strain (εₐ) |
|---|---|---|---|---|
| AlN; (Template layer) | 100%; | 0.31008; | 0.49906; | -0.329% |
| ud-AlGaN layer; (first buffer layer) | 86.8%; | 0.31011; | 0.50252; | -0.651% |
| ud-AlGaN layer; (Second buffer layer). | 77.4%; | 0.31019; | 0.50498; | -0.861% |
| n-AlGaN layer; (First electron injectionlayer). | 77.4%; | 0.31019; | 0.50498; | -0.861% |
| n-AlGaN layer; (Second electron injection layer). | 73.8%; | 0.31027 | 0.50588; | -0.925% |
| MQW wells; | 42.5%; | 0.31034; | -1.691% | |
| MQW barrier; | 65.5%; | 0.31034; | -1.113% | |

The a- and c-axis lattice constants are in nanometers (nm).

The following were estimated from the XRD-RSM image according to the reference example.

**(Table 2)**

| Layer name; a-axial lattice constant; c-axial lattice constant | | |
|---|---|---|
| AlN; (Template). | 0.31062; | 0.49863 |
| AlGaN; | 0.31093; | 0.50493 |

The a- and c-axis lattice constants are in nanometers (nm).
The Al molar fraction of AlGaN is 75.1%. The relaxation rate of AlGaN to the AlN templates is 12.8%. The in-plane strain rate (εₐ) of the AlN template is 0.15%. The in-plane strain rate (εₐ) of AlGaN is 0.68%.

The AlN template layer 20 and the AlN homo-epitaxial layer 30 are observed as the single peak. The lattice relaxation rate of the buffer layer 40 to the AlN layer is approximately zero, the buffer layer 40 maintains the crystallinity of the AlN layer. In the table above, the AlN template layer 20 and the AlN homo-epitaxial layer 30 is referred to as "AlN".

The a-axis lattice constant of AlN according to the embodiment is smaller than that of AlN of the reference example, and accordingly, the absolute value of the in-plane distortion rate of the AlN layer according to the embodiment is larger. This indicates that the AlN layer have a large in-plane compressive strain.

The relaxation rate of the electron injection layer 50 according to the embodiment is smaller than that of the electron injection layer of the reference example. This indicates that the AlN layer according to the embodiment has a small density of threading dislocations and provides a base for the electron injection layer 50.

The electron injection layer 50 according to the embodiment is provided with a large absolute value as compared with that of the reference example, which indicates that the electron injection layer 50 has a large in-plane compressive strain. The large in-plane compressive strain of the electron injection layer 50 results from a large compressive strain of the AlN layer and a small relaxation rate of the electron injection layer 50 to the AlN layer.

Referring to FIGs. 23A and 23B and Table 1, the reciprocal lattice mapping of the epi-structure described above shows that the epi-structure according to the embodiment provides the first electron injection layer 52 with a lattice relaxation rate of 2% or less to the template layer 20.

Referring to FIGs. 23A and 23B and Table 1, the reciprocal lattice mapping of the epi-structure described above shows that the AlGaN of the well layer 61 of the active layer 60 has a compressive strain of 1.5% or more.

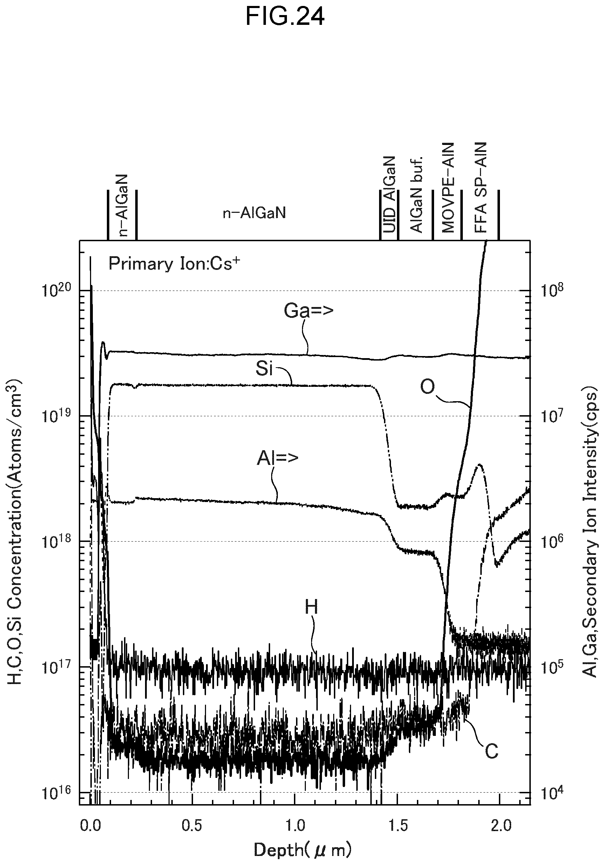

FIG. 24 is a view showing results of SIMS analysis (the profiles of impurity concentrations in the depth direction) of the nitride semiconductor laminate (including the two-layered electron injection layer) according to the embodiment. The vertical axis represents ion counts, and the horizontal axis represents the depth measured from the surface of the nitride semiconductor stack. The topmost layer of the nitride semiconductor stack is the electron injection layer 50, the film thickness of which is 1300 nm.

| Layer name; | Range in Horizontal axis (depth associated with SIMS spectrometry) | |
|---|---|---|
| Second electron injection layer 51; | 0.1 to 0.2 µm. (n-AlGaN) | |
| First electron injection layer 52; | 0.2 to 1.4 µm. (n-AlGaN) | |
| Buffer layer 40; | 1.4 to 1.7µm. (AlGaN buf.) | |
| | | (UID AlGaN) |
| AlN homo-epitaxial layer 30; | 1.7 to 1.8 µm. (MOVPE-AlN) | |
| AlN template layer 20; | 1.8 to 2.0 µm. (FFA-AP-AlN) | |

Ion species analyzed are listed below: hydrogen (H), carbon (C), oxygen (O), and silicon (Si). Regarding the nitride semiconductor laminate (the two-layered electron injection layer), the present analysis of the first electron injection layer 51 is listed below: hydrogen (H) of 9.0×10¹⁶ cm^{-3;} carbon (C) of 2.8×10¹⁶ cm⁻³; oxygen (O) of 1.8×10¹⁶cm⁻³; and silicon (Si) of 1.7×10¹⁹ cm⁻³. Regarding the second electron injection layer 52, oxygen (O) is 2.4×10¹⁶ cm⁻³, and the concentrations of the other elements are substantially the same as those of the first electron injection layer 51. The second electron injection layer 52 has a higher oxygen concentration than that of the first electron injection layer 51, since the substrate temperature of the second electron injection layer 52 is lower than that of the first electron injection layer 51. In the first and second electron injection layers 51 and 52 that have substantially the same Al molar fraction, the first and second electron injection layers 51 and 52 can be distinguished from each other by the distribution of impurities, e.g., oxygen. Regarding at least one element concentration of hydrogen, carbon, and oxygen, the first and second electron injection layers 51 and 52 may be different from each other. Elements, H, C, and O, of the electron injection layer 50 each exhibit a low concentration near the detection limit in the embodiment. Such low impurity concentrations contribute to suppression of light absorption in the electron injection layer 50.

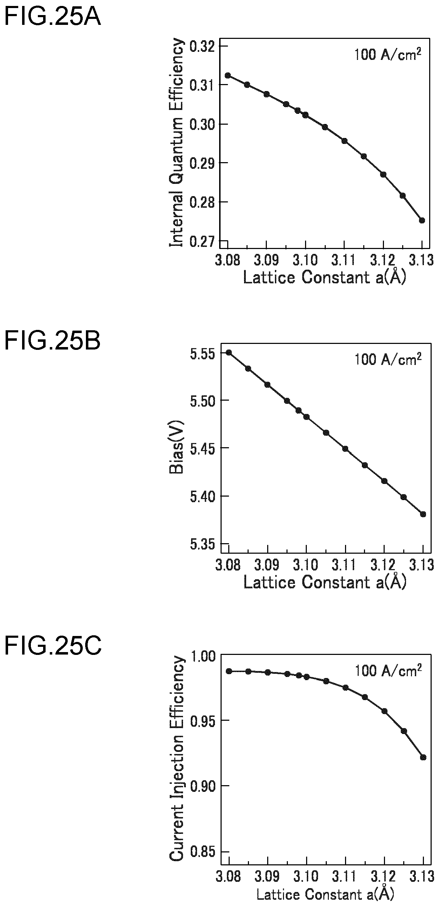

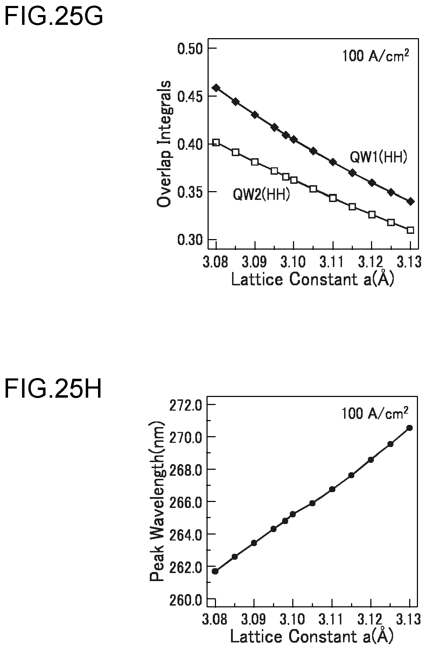

FIGs. 25A to 25H are views illustrating the relationships between the in-plane lattice constant of the electron injection layer 50 and the properties of the light-emitting diode according to an embodiment. These relationships were obtained by simulation. In the simulation model, the active layer 60, the electron block layer 70, and the hole injection layer 80 have the same in-plane lattice constants of the electron injection layer 50, which is satisfied by the active layer 60, the electron block layer 70, and the hole injection layer 80 being coherently grown with respect to the electron injection layer 50. The contact layer 90 has a lattice relaxation rate of 0.8 (80%) relative to the electron injection layer 50. More particularly, the horizontal axes of the FIGs. 25A to 25H each indicate the in-plane lattice constant of the electron injection layer 50, which is varied as parameter in calculating the properties of the light-emitting diodes. The respective vertical axes of FIGs. 25A and 25H indicate the internal quantum efficiency, operating voltage, electron injection efficiency, current leakage rate, electron barrier height, hole barrier height, overlap integrals in the quantum wells, and peak emission wavelengths of the light-emitting diodes. The internal quantum efficiency, operating voltage, electron injection efficiency, current leakage rate, electron barrier height, hole barrier height, overlap integral in the quantum wells, and peak emission wavelengths are derived by the simulations at an injection current density of 100 A/cm².

Fig. 25A is a view showing a relationship between the internal quantum efficiency of the light-emitting diode and the in-plane lattice constant of the electron injection layer 50 according to the embodiment. The internal quantum efficiency increases as the in-plane lattice of the electron injection layer 50 decreases.

Fig. 25B is a view showing the relationship between the operating voltage of the light-emitting diode and the in-plane lattice constant of the electron injecting layer 50 according to the embodiment. Decrease in the in-plane lattice of the electron injection layer 50 increases the operating voltage.

FIG. 25C is a view showing a relationship between the electron injection efficiency and the in-plane lattice constant of the electron injection layer 50 of the light-emitting diode according to the embodiment. Decrease in the in-plane lattice constant of the electron injection layer 50 increases the current injection efficiency.

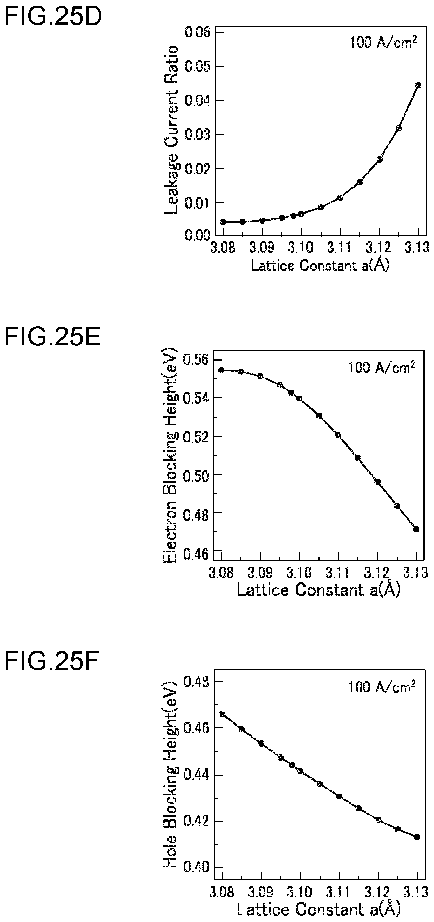

FIG. 25D is a view showing the relationship between the current leakage rate and the in-plane lattice constant of the electron injection layer 50 of the light-emitting diode according to the embodiment. The current leakage rate is a ratio of, relative to the current applied to the light-emitting diode, the current that is carried by electrons and holes to the n-side and p-side electrodes, respectively, without recombining in the light-emitting diode. The contribution of holes reaching the n-side electrode is negligibly small, so that the current leakage rate is determined by the fraction of electrons reaching the p-side electrode. The current leakage rate of the light-emitting diode decreases as the in-plane lattice of the electron injection layer 50 decreases.

FIG. 25E is a view showing a relationship between the electron barrier height and the in-plane lattice constant of the electron injection layer 50 of the light-emitting diode according to the embodiment. The electron barrier height is a magnitude of the effective energy barrier of the electron block layer 70 against electrons. Specifically, the electron barrier height is as defined as the maximum value of the difference in energy between the conduction band and the pseudo-Fermi level of electron of the electron block layer 70. Decrease in the in-plane lattice of the electron injection layer 50 increases the electron barrier height.

FIG. 25F is a view showing a relationship between the hole barrier height and the in-plane lattice constant of the electron injection layer 50 of the light-emitting diode according to the embodiment. The height of the hole barrier is a magnitude of the effective energy barrier of the layer against hole. Specifically, it is as defined as the maximum of the difference in energy between the pseudo Fermi level of the hole and the valence band of the layer. Decrease in the in-plane lattice of the electron injection layer 50 increases the height of the hole barrier of the light-emitting diode.

Fig. 25G is a view showing the relationship between the in-plane lattice constant of the electron injection layer 50 and the squared overlap integral of the wave functions of electron and hole in the active layer 60 of the light-emitting diode according to the embodiment. Specifically, FIG. 25G shows the squared overlap integral of the wave functions of electron and heavy hole (heavy hole: HH), which were calculated for the nearest well layer 61 (the first quantum well) to the electron injection layer 50 and the next nearest well layer 61 (the second quantum well) thereto. This overlap integral becomes larger as the in-plane lattice of the electron injection layer 50 becomes smaller.

FIG. 25H is a view showing the relationship between the peak emission wavelength and the in-plane lattice constant of the electron injection layer 50 of the light-emitting diode according to the embodiment. The peak emission wavelength is becomes shorter as the in-plane lattice constant of the electron injection layer 50 becomes smaller.

The results shown in FIG s. 25A to 25H are based on the following physical picture. Decrease in the in-plane lattice constant of the electron injection layer 50 enhances the compressive strain applied to the active layer 60 and the electron block layer 70. Increase in the compressive strain changes piezo polarization therein, which leads to variation in the band lineup. This variation makes the heights of the electron barrier and the hole barrier enhanced. This enhancement of these barrier heights allows the electron blocking layer 70 to more effectively suppress electron overflow, resulting in a reduced current leakage rate, and improved carrier injection efficiency and internal quantum efficiency. The increase in the electron and hole barrier heights also raises the operating voltage. Further, reduction in the in-plane lattice constant of the electron injection layer 50 increases the compressive strain applied to the active layer 60, thereby varying the internal electric field of the active layer 60 due to change in piezo polarization. This variation weakens the quantum-confined Stark-effect (Quantum confined Stark effect: QCSE) to increase the overlap integral of the electron and hole wave functions in the active layers 60. The increase in the overlap integral enhances the emission recombination probability, which results in a higher internal quantum efficiency. Further, the reduction of QCSE enhances the effective bandgap energy of the quantum well, which shifts the emission wavelength to shorter wavelengths. Accordingly, the light-emitting diode according to the embodiment is provided with a compressively-strained electron injection layer 50, and thus has excellent device characteristics.

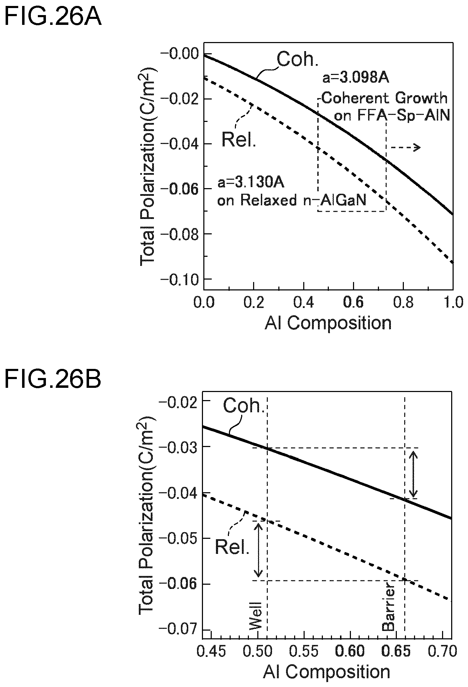

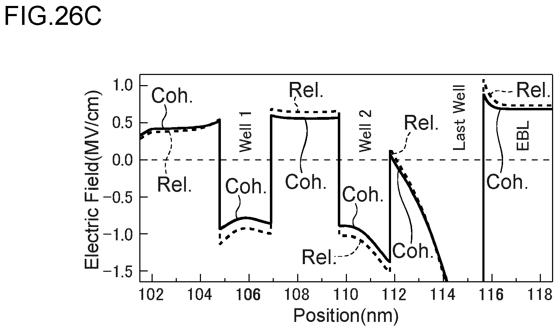

FIGs. 26A to 26C are views showing the relationship between the Al molar fraction of the active layer and the total polarization (the sum of spontaneous and piezo polarizations). Specifically, FIG. 26A is a view showing the relationship, referred as "Coh", between the Al molar fraction of the well or barrier layer and the total polarization of AlGaN of the in-plane lattice constant of 0.3098 nm (i.e., AlGaN coherently grown on the AlN template layer 20), and the relationship, referred as "Rel.", between the Al molar fraction of the well or barrier layer and the total polarization of AlGaN of the in-plane lattice constant of 0.3130 nm (i.e., AlGaN grown on the fully relaxed AlGaN (Al molar fraction of 0.75). FIG. 26B is a partially enlarged view of FIG. 26A. Referring to Fig. 26B, the difference in the total polarization between the well layer 61 of an Al molar fraction of 0.51 and the barrier layer 62 of an Al molar fraction of 0.66 were estimated. In the AlGaN of the in-plane lattice constant of 0.3098 nm, the total polarization difference was 0.01123 C/m², while in the AlGaN of the in-plane lattice constant of 0.3130 nm, the total polarization difference was 0.01296 C/m². When the electron injection layer 50 is compressively strained, the difference in the total polarization of the well and barrier layers 61 and 62 of the active layer 60, which is formed on the electron injection layer 50, is reduced. FIG. 26C is a view showing both the interior electric fields of the active layer 60, formed on the electron injection layer 50 with the in-plane lattice constant of 0.3098 nm, and the active layer, formed on the electron injection layer 50 with the in-plane lattice constant of 0.3130 nm. The large compressive strain from the template layer 20 reduces the difference in total polarization between the well and barrier layers 61 and 62. The small total polarization difference can reduce the absolute value of the internal electric field of the well layer 61 of the active layer 60. This small internal electric field of the well layer 61 makes the QCSE small.

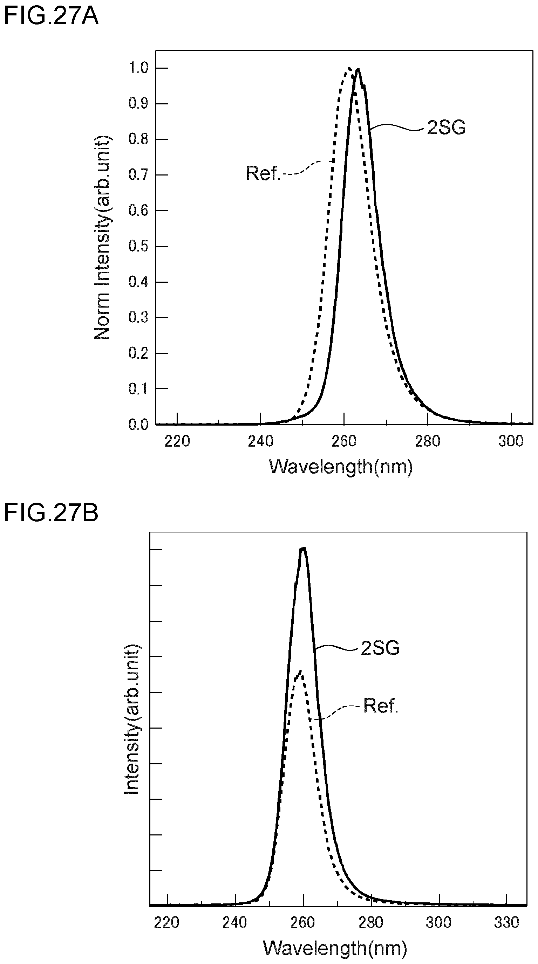

FIGs. 27A and 27B are views showing light emission spectra of light-emitting diodes according to the reference example and the embodiment. FIG. 27A shows the normalized emission spectral intensity of these light-emitting diodes, and FIG. 27B shows the emission spectral intensity without normalization of the light-emitting diodes. Specifically, these are views showing the emission spectrum, referred as "2SG", of the light-emitting diode that includes the two-layered electron injection layer 50 (two growth step: 2SG) and the emission spectrum, referred as "Ref.", of the light-emitting diode that includes a single-layered electron injection layer. The emission spectrum "2SG" has a full width at half maximum of 9.6 nm at an emission wavelength of 263.6 nm. The emission spectrum "Ref." has a full width at half maximum of 11.5 nm at an emission wavelength of 260.8 nm.

Regarding the emission spectrum of the light-emitting diode according to the embodiment, the full width at half maximum of is less than 11.5 nm, and can be made 10 nm or less.

Technical aspects of the electron injection layer 50 (the first and second electron injection layers 52 and 51) will be described below. The deep ultraviolet light-emitting diode requires the following technical matters regarding the Al molar fraction of the underlying electron injection layer 50 (e.g., n-type AlGaN) of the active layer 60.

First, the deep ultraviolet light emitted from the active layer being capable of transmitting through the underlying electron injection layer 50

Specifically, when the emission wavelength is 285 nm, AlGaN of the electron injection layer 50 is required to have an Al molar fraction of 40% or more. When the emission wavelength is 265 nm, AlGaN of the electron injection layer 50 is required to have an Al molar fraction of 60% or more. When the emission wavelength is 230 nm, AlGaN of the electron injection layer 50 is required to have an Al malar fraction of 90% or more.

Second, AlGaN of the electron injection layer 50 grown with a lattice-relaxation rate of 2% or less relative to the underlying semiconductor
Misfit dislocations, which are produced by the lattice relaxation of AlGaN of the electron injection layer, lower the compressive strain of the active layer, which makes the luminous efficacy degraded. In order to avoid the lattice relaxation of the AlGaN of the electron injection layer 50, the electron injection layer 50 is grown as AlGaN of a lattice relaxation rate of 2% or less relative to the underlying AlN template layer or AlN substrate. For this purpose, typically, the Al molar fraction of AlGaN of the electron injection layer 50 is preferably 50% or more, more preferably 60% or more, and still more preferably 70% or more. From the viewpoint of growing the AlGaN onto AlN, the electron injection layers 50 may include AlGaN of a larger Al molar fraction.

The following are AlN template bases fabricated on sapphire substrates and their properties.

| AlN film thickness; annealing temp.; | | AlN(0002); AlN(10-12) | |
|---|---|---|---|
| 120 nm; | 1725 degrees Celsius; 60 arcsec; | | 397 arcsec |
| 165 nm; | 1725 degrees Celsius; 43 arcsec; | | 323 arcsec |
| 250 nm; | 1725 degrees Celsius; 36 arcsec; | | 255 arcsec |
| 500 nm; | 1725 degrees Celsius; 39 arcsec; | | 186 arcsec |
| 500 nm; | 1500 degrees Celsius; 90 arcsec; | | 359 arcsec |
| 500 nm; | 1525 degrees Celsius; 100 arcsec; | | 368 arcsec |
| 500 nm; | 1550 degrees Celsius; 33 arcsec; | | 258 arcsec |
| 500 nm; | 1600 degrees Celsius; 32 arcsec; | | 227 arcsec |

| AlN film thickness; annealing temp.; | | AlGaN(0002); AlGaN(10-12) | |
|---|---|---|---|
| 120 nm; | 1725 degrees Celsius; 111 arcsec; | | 443arcsec |
| 165 nm; | 1725 degrees Celsius; 73 arcsec; | | 337arcsec |
| 250 nm; | 1725 degrees Celsius; 56 arcsec; | | 266arcsec |
| 500 nm; | 1725 degrees Celsius; 42 arcsec; | | 170arcsec |
| 500 nm; | 1500 degrees Celsius; 251 arcsec; | | 474arcsec |
| 500 nm; | 1525 degrees Celsius; 252 arcsec; | | 474arcsec |
| 500 nm; | 1550 degrees Celsius; 127 arcsec; | | 316arcsec |
| 500 nm; | 1600 degrees Celsius; 88 arcsec; | | 217arcsec |

Several aspects of the present invention will be described below.

A III nitride light-emitting device according to the first aspect includes: a support having a principal surface made of material different from III nitride, and a template member including an AlxGai-xN, wherein the AlxGai-xN has a full width at half maximum of a (10-12)-face X-ray rocking curve of 1000 arcsec or less, where X is greater than zero and equal to or less than 1, and the template member covers the principal surface of the support and includes compressive strain; an active layer disposed on the template member so as to generate light having a peak wavelength in deep ultraviolet wavelengths of 285 nm or lower, the active layer including a AlGaN that contains compressive strain, and an n-type III nitride semiconductor region disposed between the template member and the active layer, wherein the n-type III nitride semiconductor region is disposed between the template layer and the active layer, the n-type III nitride semiconductor region including an n-type first III nitride semiconductor layer and an n-type second III nitride semiconductor layer that is disposed between the n-type first III nitride semiconductor layer and the active layer, wherein the n-type first III nitride semiconductor layer includes a lattice relaxation rate of 2% or less relative to the template layer, and wherein the n-type first III nitride semiconductor layer has a surface roughness of 0.4nm or less.

This light-emitting device provides the n-type second III nitride semiconductor layer with a surface roughness of 0.4 nm or less, and the n-type second III nitride semiconductor layer is disposed on the n-type first III nitride semiconductor layer, thereby avoiding the lattice relaxation of the active layer to incorporate compressive strain therein. Further, the n-type first III nitride semiconductor layer, which is disposed on the template layer of AlxGai-xN with a full width at half maximum of a (10-12)-face X-ray locking curve of 1000 arcsec, is provided with a lattice relaxation rate of 2% or less with respect to the template layer, thereby bringing, to the n-type second III nitride semiconductor layer, the compressive strain embedded in the template layer.

In the III nitride light-emitting device according to the first aspect, AlGaN of the active layer can be provided with a compressive strain of 1.5% or more.

This light-emitting device can provide the well layer of the active layer with a compressive strain of 1.5% or more.

In the III nitride light-emitting device according to the first aspect, the III nitride light-emitting device can have a full width at half maximum of emission spectrum below 10 nm.

In this light-emitting device, the above-described structure allows the active layers to generate light having an emission spectrum with a full-width at half maximum of 10 nm or below.

In the III nitride light-emitting device according to the first aspect, the active layer may include a compressively-strained well layer and a compressively-strained barrier layer.

In this light-emitting device, the compressive strains of the well and barrier layers can enhance the intensity of light emission from the active layer with the action of the quantum confinement Stark effect.

In the light-emitting device according to the first embodiment, the AlxGai-xN of the template layer can be AlN.

The light-emitting device provides the template layer with a compressively strained AlN as the AlxGai-xN. This compressive strain, acting as a source, is applied to the active layer.

In the light-emitting device according to the first aspect, the thickness of the n-type first III nitride semiconductor layer may be larger than that of the n-type second III nitride semiconductor layer. Further, a first Al molar fraction of the n-type first III nitride semiconductor layer may be larger than a second Al molar fraction of the n-type second III nitride semiconductor layer.

According to this light-emitting device, the magnitude relationships of the Al molar fraction and the film thickness are less likely to cause relaxation of AlGaNs in the n-type first and second III nitride semiconductor layers on the template layer, thereby making it easy to apply the compressive strain to the active layer.

In the III nitride light-emitting device according to the first aspect, the n-type first III nitride semiconductor layer may have a film thickness of 2800 nm or less, and the n-type second III nitride semiconductor layer may have a film thickness of 200 nm or less.

According to this light-emitting device, these thickness ranges are less likely to cause relaxation of AlGaNs in the n-type first and second III nitride semiconductor layers on the template layer, thereby making it easy to apply the compressive strain to the active layer.

An III nitride epitaxial wafer according to the second aspect includes a substrate having a principal surface made of material different from III nitride, and a template layer including AlxGai-xN that has a full width at half maximum of a (10-12)-face X-ray rocking curve of 1000 arcsec or less and covers the principal surface of the substrate, where X is greater than zero and not more than 1; an active layer disposed on the substrate so as to generate light having a peak wavelength in deep ultraviolet wavelengths of 285 nm or below, wherein the active layer includes an AlGaN incorporating compressive strain; and an n-type III nitride semiconductor region that is disposed between the template substrate and the active layer and includes Al as a III constituent element, wherein the n-type III nitride semiconductor region includes an n-type first III nitride semiconductor layer disposed between the template layer and the active layer, and an n-type second III nitride semiconductor layer disposed between the n-type first III nitride semiconductor layer and the active layer, wherein the n-type first III nitride semiconductor layer has a lattice relaxation rate of 2% or less with respect to the template layer, and wherein the n-type second III nitride semiconductor layer has a surface roughness of 0.4 nm or less.

This epitaxial wafer provides the n-type second III nitride semiconductor layer with a surface roughness of 0.4 nm or less, and the n-type second III nitride semiconductor layer is disposed the n-type first III nitride semiconductor layer to avoid the lattice relaxation of the active layer and allow the application of compressive strain to the active layer. Further, the n-type first III nitride semiconductor layer is disposed on the AlxGai-xN that has a full width at half maximum of a (10-12)-face X-ray locking curve of 1000 arcsec, and accordingly, is provided with a lattice relaxation rate of 2% or less relative to the template layer, thereby bringing the compressive strain, which is embedded in the template layer, to the n-type second semiconductor layer.

In the III nitride epitaxial wafer according to the second aspect, the n-type second III nitride semiconductor layer may have an Al content variation of 0.1% or less.

According to this epitaxial wafer, the incorporation efficiency of Ga is associated with the surface morphology, and smoothing the surface of the III nitride semiconductor layer allows the variation of the Al content to fall within the above numerical range.

In the III nitride epitaxial wafer according to the second aspect, the substrate may include at least one material of carbon, boron nitride (BN), aluminum oxide (sapphire), ceramics, silicon carbide, refractory metals, zirconia, tantalum carbide (TaC), and ScAlMgO₄.

This epitaxial wafer may include an exemplary material regarding the substrate.

In the III nitride epitaxial wafer according to the second aspect, the substrate has a hexagonal system as a crystal structure, the principal surface of the substrate may have an off-angle of 0.5 degrees or less relative to a c-face of the crystal structure.

This epitaxial wafer provides an exemplary angular range regarding the off-angle.

A method of fabricating a III nitride light-emitting device according to the third aspect includes: preparing a template that include a substrate having a principal surface of material different from III nitride, and a template layer covering the principal surface of the substrate and including Al_{X}Ga_{1-X}N having a full width at half maximum of a (10-12)-face X-ray rocking curve of 1000 arcsec, where X is greater than zero and less than or equal to 1; and growing, on the template layer, a III nitride semiconductor region having an n-type first III nitride semiconductor layer including an n-type dopant, and an n-type second III nitride semiconductor layer including an n-type dopant, and an active layer having a peak wavelength in deep ultraviolet wavelengths of 285 nm or below and including AlGaN, wherein the n-type first III nitride semiconductor layer is disposed between the template layer and the active layer, and the n-type second III nitride semiconductor layer is disposed between the n-type first III nitride semiconductor layer and the active layer, wherein growing, on the template layer, a III nitride semiconductor region includes growing the n-type first and second III nitride semiconductor layers using at least one of first to third conditions as follows: the first condition in which a growth temperature of the n-type first III nitride semiconductor layer is greater than that of the n-type second III nitride semiconductor layer; the second condition in which a growth rate of the n-type first III nitride semiconductor layer is greater than that of the n-type second III nitride semiconductor layer; and the third condition in which an NH₃ partial pressure of the n-type first III nitride semiconductor layer is greater than that of the n-type second III nitride semiconductor layer.

In the method of fabricating a light-emitting device, the n-type first and second III nitride semiconductor layers are grown using at least one of the first to third conditions on the template layer, which includes Al_{X}Ga_{1-X}N having a full width at half maximum of a (10-12)-face X-ray locking curve of 1000 arcsec or lower.

The growth of the n-type first III nitride semiconductor layer can suppress the generation of dislocations and hillocks due to screw dislocations, and the growth of the n-type second III nitride semiconductor layer can provide the surface thereof with the flatness superior to that of the n-type first III nitride semiconductor layer. The AlGaNs of the active layer in the III nitride laminate are grown on this excellent underlying region. The excellent flatness allows the active layer to be compressively strained to enhance the optical power (light output per input power) of the active layer in the deep ultraviolet wavelengths of 285 nm or shorter.

In the method of fabricating a III nitride light-emitting device according to the third aspect, the growth temperature of the n-type first III nitride semiconductor layer is 1100 degrees Celsius or more, and the growth temperature of the n-type second III nitride semiconductor layer may be less than 1100 degrees Celsius.

This fabricating method provides the second condition with exemplary growth temperatures.

In the method of fabricating a III nitride light-emitting device according to the third aspect, the growth rate of the n-type first III nitride semiconductor layer is 400 nm/h or less, and the growth rate of the n-type second III nitride semiconductor layer may be greater than 400 nm/h.

This fabrication method provides the second condition with exemplary growth rates.

In the method of fabricating a III nitride light-emitting device according to the third aspect, the NH₃ partial pressure of the n-type first III nitride semiconductor layer is not less than 10 kPa, and the NH₃ partial pressure of the n-type second III nitride semiconductor layer may be less than 10 kPa.

This fabrication method provides the third condition with exemplary partial pressures of ammonia.

In the methods of fabricating a III nitride light-emitting device according to the third aspect, the n-type first III nitride semiconductor layer may be an AlGaN layer having an Al molar fraction of 0.7 or more. Further, the n-type second III nitride semiconductor layer may be an AlGaN layer having an Al molar fraction of 0.7 or more.

This fabrication process allows these Al molar fraction ranges makes it easy to maintain the step terraces in a linear manner in growing AlGaN of the n-type second nitride III semiconducting layer onto the template layer, thereby reducing the generation of non-luminous centers due to the wandering of steps.

In the method of fabricating a III nitride light-emitting device according to the third aspect, the thickness of the n-type first III nitride semiconductor layer may be larger than that of the n-type second III nitride semiconductor layer. Further, the n-type first III nitride semiconductor layer of the first Al molar fraction may be larger than the second Al molar fraction of the n-type second III nitride semiconductor layer.

This fabricating process forms the n-type III nitride semiconductor region of the two n-type III nitride semiconductor layers, the first and second Al molar fractions of which are different from each other, (e.g., n-type AlGaN layers). The n-type second III nitride semiconductor layer is provided with a low density of dislocations and an excellent surface morphology by using the following condition: the first Al molar fraction being greater than the second Al content; and the thickness of the n-type second III nitride semiconductor layer being larger than that of the n-type first III nitride semiconductor layer. When the n-type first III nitride semiconducting layer of a relatively higher Al molar fraction is grown using at least any one of the first to third conditions, the increase in hillocks can be reduced, and the disturbance of step-growth can be reduced so as not to be large, thereby allowing the morphology to be improved. The active layer is provided with a low density of dislocation and compressive strain from the template layer. The active layer can incorporate compressive strain depending on the AlxGai-xN template layer.

In the method of fabricating a III nitride light-emitting device according to the third aspect, the substrate may comprise at least one material of carbon, boron nitride (BN), aluminum oxide (sapphire), ceramics, silicon carbide, refractory metals, zirconia, tantalum carbide (TaC), and ScAlMgO₄.

This fabricating method provides the substrate with an exemplary material.

In the method of fabricating a III nitride light-emitting device according to the third aspect, the substrate may have a hexagonal crystalline structure and the substrate may have an off-angle of 0.5 degrees or less relative to the c-face of the substrate.

This fabricating method provides the off angle with exemplary angles from the viewpoint of crystal growth.

In the method of fabricating a III light-emitting device according to a third embodiment, the AlxGai-xN of the template layer can be AlN.

This fabricating method provides an AlN as the AlxGai-xN with the template layer that includes compressive strain. This compressive strain, acting as a source, is applied to the active layer.

The invention is not limited to the above-described embodiments, and can be implemented in various ways without departing from the scope of the invention. Then, they are all included in the technical concept of the present invention.

10... substrate, 20...template layer, 30...homo-epitaxial layer, 40...buffer layer, 41...first buffer layer. 42...second buffer layer, 50...electron injection layer, 51...first electron injection layer, 52...second electron injection layer, 53...n-side electrode, 60...active layer, 61...well layer, 62...barrier layer, 70...electron block layer, 80...hole injection layer, 90...contact layer, 91...first contact layer, 92...second contact layer, 93...p-side electrode 93, 110...light emitting device, 112...template member, 113...n-type III nitride laminate, 114...active layer, 114a...quantum well structure, 114b...well layer, ]114c...barrier layer, 115...upper III nitride laminate, 116... n-type III nitride semiconductor region, 118...support, 118a...principal surface, 120...template layer, 120a...first region, 120b...second region, 122...n-type first III nitride semiconductor layer, 124...n-type second III nitride semiconductor layer, 134...electron block layer, 136...p-type compositionally-graded layer, 138, 138a, 138b...p-type contact layer, 142...processed region, 144...passivation film, 146...p-side electrode, 148...n-side electrode, 150...III nitride epitaxial wafer, 150a...major face, 151...precursor, 152a...major face, 153...semiconductor layer structure, 156...substrate, 156a...majorface, 160...template layer, 162...template, 164 ... III nitride laminate, 165...III nitride semiconductor layer, 166...III nitride semiconductor region, 167...III nitride semiconductor layer, 168...active layer, 168a...quantum well structure, 168b...well layer, 168c...barrier layer, 174...electron block layer, 176...p-type compositionally-graded layer, 178...p-type contact layer, 180...trench, 182...etched region, 183...trench, 184...passivation film, 184a...opening, 184b...opening, 186, 188...electrode

## Claims

1. A III nitride light-emitting device comprising:
a template member including a support having a principal surface and a template layer covering the principal surface of the support, the principal surface being made of material different from III nitride, the template layer including compressive strain, the template layer including an AlxGai-xN, and the AlxGai-xN having a full width at half maximum of a (10-12)-face X-ray rocking curve of 1000 arcsec or lower, where X is greater than zero and equal to or less than 1;
an active layer disposed on the template member so as to generate light having a peak wavelength in deep ultraviolet wavelengths of 285 nm or below, the active layer including a compressively strained AlGaN, and
an n-type III nitride semiconductor region disposed between the template member and the active layer, the n-type III nitride semiconductor region containing Al as a III constituent element,
the n-type III nitride semiconductor region including:
an n-type first III nitride semiconductor layer disposed between the template layer and the active layer; and
an n-type second III nitride semiconductor layer disposed between the n-type first III nitride semiconductor layer and the active layer,
the n-type first III nitride semiconductor layer including a lattice relaxation rate of 2% or less relative to that of the template layer, and
the n-type second III nitride semiconductor layer having a surface roughness of 0.4 nm or less.

2. The III nitride light-emitting device according to claim 1, wherein the active layer includes a well layer of AlGaN having a compressive strain of 1.5% or more.

3. The III nitride light-emitting device according to claim 1 or 2, wherein the III nitride light-emitting device has an emission spectrum of a full width at half maximum of 10 nm or below.

4. The III nitride light-emitting device according to any one of claims 1 to 3, wherein the active layer includes a compressively-strained well layer and a compressively-strained barrier layer.

5. The III nitride light-emitting device according to any one of claims 1 to 4, wherein the n-type first III nitride semiconductor layer has a thickness larger than that of the n-type second III nitride semiconductor layer, and
the n-type first III nitride semiconductor layer has a first Al molar fraction larger than a second Al molar fraction of the n-type second III nitride semiconductor layer.

6. The III nitride light-emitting device according to any one of claims 1 to 5, wherein a film thickness of the n-type first III nitride semiconductor layer is 2800 nm or less, and a film thickness of the n-type second III nitride semiconductor layer is 200 nm or less.

7. A III nitride epitaxial wafer comprising:
a template substrate having a principal surface made of material different from III nitride, a template layer including AlxGai-xN that has a full width at half maximum of a (10-12)-face X-ray rocking curve of 1000 arcsec or less, where X is greater than zero and not more than 1, and the template layer covering the principal surface of the substrate and including compressive strain;
an active layer disposed on the template substrate so as to generate light having a peak wavelength in deep ultraviolet wavelengths of 285 nm or below, the active layer including an AlGaN, and the AlGaN incorporating compressive strain; and
an n-type III nitride semiconductor region disposed between the template substrate and the active layer, and including Al as a III constituent element,
the n-type III nitride semiconductor region including an n-type first III nitride semiconductor layer disposed between the template layer and the active layer, and an n-type second III nitride semiconductor layer disposed between the n-type first III nitride semiconductor layer and the active layer,
the n-type first III nitride semiconductor layer having a lattice relaxation rate of 2% or less relative to the template layer, and
the n-type second III nitride semiconductor layer having a surface roughness of 0.4 nm or less.

8. The III nitride epitaxial wafer according to claim 7, wherein the n-type second III nitride semiconductor layer has an Al molar fraction variation of 0.1% or less.

9. The III nitride epitaxial wafer according to claim 7 or 8, wherein the substrate includes at least one material of carbon, boron nitride (BN), aluminum oxide (sapphire), ceramics, silicon carbide, refractory metals, zirconia, tantalum carbide (TaC), or ScAlMgO₄.

10. The III nitride epitaxial wafer according to any one of claims 7 to 9, wherein the substrate has a hexagonal system as a crystal structure, the principal surface of the substrate has an off-angle of 0.5 degrees or less relative to c-plane of the crystal structure.

11. A method for fabricating a III nitride light-emitting device comprising:
preparing a template that includes a substrate having a principal surface of material different from III nitride, and a template layer that covers the principal surface of the substrate and includes AlxGai-xN having a full width at half maximum of a (10-12)-face X-ray rocking curve of 1000 arcsec, where X is greater than zero and less than or equal to 1; and
growing, on the template layer, a III nitride semiconductor region, the III nitride semiconductor region having an n-type first III nitride semiconductor layer doped with an n-type dopant, and an n-type second III nitride semiconductor layer doped with an n-type dopant, and an active layer including AlGaN and having a peak wavelength in deep ultraviolet wavelengths of 285 nm or below,
wherein the n-type first III nitride semiconductor layer is disposed between the template layer and the active layer,
wherein the n-type second III nitride semiconductor layer is disposed between the n-type III nitride semiconductor layer and the active layer,
wherein growing, on the template layer, a III nitride semiconductor region includes growing the n-type first III nitride semiconductor layer and the n-type second III nitride semiconductor layer using at least one of first to third conditions as follows:
the first condition in which a growth temperature of the n-type first III nitride semiconductor layer is greater than that of the n-type second III nitride semiconductor layer;
the second condition in which a growth rate of the n-type first III nitride semiconductor layer is greater than that of the n-type second III nitride semiconductor layer; and
the third condition in which an NH₃ partial pressure of the n-type first III nitride semiconductor layer is greater than that of the n-type second III nitride semiconductor layer.

12. The method according to claim 11, wherein a growth temperature of the n-type first III nitride semiconductor layer is 1100 degrees Celsius or more,
a growth temperature of the n-type second III nitride semiconductor layer is less than 1100 degrees Celsius,
a growth rate of the n-type first III nitride semiconductor layer is 400 nm/h or less,
a growth rate of the n-type second III nitride semiconductor layer is greater than 400 nm/h,
an NH₃ partial pressure of the n-type first III nitride semiconductor layer is not less than 10 kPa, and
an NH₃ partial pressure of the n-type second III nitride semiconductor layer is less than 10 kPa.

13. The method according to claim 11, wherein the n-type first III nitride semiconductor layer is an AlGaN layer having an Al molar fraction of 0.7 or more, and the n-type second III nitride semiconductor layer is an AlGaN layer having an Al molar fraction of 0.7 or more.

14. The method according to any one of claims 11 to 13, wherein a thickness of the n-type first III nitride semiconductor layer is larger than that of the n-type second III nitride semiconductor layer, and a first Al molar fraction of the n-type first III nitride semiconductor layer is larger than a second Al molar fraction of the n-type second III nitride semiconductor layer.

15. The method according to any one of claims 11 to 14, wherein the substrate includes at least one material of carbon, boron nitride (BN), aluminum oxide (sapphire), ceramics, silicon carbide, refractory metals, zirconia, tantalum carbide (TaC), or ScAlMgO₄.

16. The method according to any one of claims 11 to 15, wherein the substrate has a hexagonal crystalline structure and an off-angle of 0.5 degrees or less relative to c-face of the substrate.

## Amended claims

### Amended claims under Art. 19.1 PCT

1. A III nitride light-emitting device comprising:
a template member including a support having a principal surface and a template layer covering the principal surface of the support, the principal surface being made of material different from III nitride, the template layer including compressive strain, the template layer including an AlxGai-xN, and the AlxGai-xN having a full width at half maximum of a (10-12)-face X-ray rocking curve of 1000 arcsec or lower, where X is greater than zero and equal to or less than 1;
an active layer disposed on the template member so as to generate light having a peak wavelength in deep ultraviolet wavelengths of 285 nm or below, the active layer including a compressively strained AlGaN, and
an n-type III nitride semiconductor region disposed between the template member and the active layer, the n-type III nitride semiconductor region containing Al as a III constituent element,
the n-type III nitride semiconductor region including:
an n-type first III nitride semiconductor layer disposed between the template layer and the active layer; and
an n-type second III nitride semiconductor layer disposed between the n-type first III nitride semiconductor layer and the active layer,
the n-type first III nitride semiconductor layer including a lattice relaxation rate of 2% or less relative to that of the template layer, and
the n-type second III nitride semiconductor layer having a surface roughness of 0.4 nm or less.

2. The III nitride light-emitting device according to claim 1, wherein the active layer includes a well layer of AlGaN having a compressive strain of 1.5% or more.

3. The III nitride light-emitting device according to claim 1 or 2, wherein the III nitride light-emitting device has an emission spectrum of a full width at half maximum of 10 nm or below.

4. The III nitride light-emitting device according to any one of claims 1 to 3, wherein the active layer includes a compressively-strained well layer and a compressively-strained barrier layer.

5. The III nitride light-emitting device according to any one of claims 1 to 4, wherein the n-type first III nitride semiconductor layer has a thickness larger than that of the n-type second III nitride semiconductor layer, and
the n-type first III nitride semiconductor layer has a first Al molar fraction larger than a second Al molar fraction of the n-type second III nitride semiconductor layer.

6. The III nitride light-emitting device according to any one of claims 1 to 5, wherein a film thickness of the n-type first III nitride semiconductor layer is 2800 nm or less, and a film thickness of the n-type second III nitride semiconductor layer is 200 nm or less.

7. A III nitride epitaxial wafer comprising:
a template substrate having a principal surface made of material different from III nitride, a template layer including AlxGai-xN that has a full width at half maximum of a (10-12)-face X-ray rocking curve of 1000 arcsec or less, where X is greater than zero and not more than 1, and the template layer covering the principal surface of the substrate and including compressive strain;
an active layer disposed on the template substrate so as to generate light having a peak wavelength in deep ultraviolet wavelengths of 285 nm or below, the active layer including an AlGaN, and the AlGaN incorporating compressive strain; and
an n-type III nitride semiconductor region disposed between the template substrate and the active layer, and including Al as a III constituent element,
the n-type III nitride semiconductor region including an n-type first III nitride semiconductor layer disposed between the template layer and the active layer, and an n-type second III nitride semiconductor layer disposed between the n-type first III nitride semiconductor layer and the active layer,
the n-type first III nitride semiconductor layer having a lattice relaxation rate of 2% or less relative to the template layer, and
the n-type second III nitride semiconductor layer having a surface roughness of 0.4 nm or less.

8. The III nitride epitaxial wafer according to claim 7, wherein the n-type second III nitride semiconductor layer has an Al molar fraction variation of 0.1% or less.

9. The III nitride epitaxial wafer according to claim 7 or 8, wherein the substrate includes at least one material of carbon, boron nitride (BN), aluminum oxide (sapphire), ceramics, silicon carbide, refractory metals, zirconia, tantalum carbide (TaC), or ScAlMgO₄.

10. The III nitride epitaxial wafer according to any one of claims 7 to 9, wherein the substrate has a hexagonal system as a crystal structure, the principal surface of the substrate has an off-angle of 0.5 degrees or less relative to c-plane of the crystal structure.

11. A method for fabricating a III nitride light-emitting device comprising:
preparing a template that includes a substrate having a principal surface of material different from III nitride, and a template layer that covers the principal surface of the substrate and includes AlxGai-xN having a full width at half maximum of a (10-12)-face X-ray rocking curve of 1000 arcsec, where X is greater than zero and less than or equal to 1; and
growing, on the template layer, a III nitride semiconductor region, the III nitride semiconductor region having an n-type first III nitride semiconductor layer doped with an n-type dopant, and an n-type second III nitride semiconductor layer doped with an n-type dopant, and an active layer including AlGaN and having a peak wavelength in deep ultraviolet wavelengths of 285 nm or below,
wherein the n-type first III nitride semiconductor layer is disposed between the template layer and the active layer,
wherein the n-type second III nitride semiconductor layer is disposed between the n-type III nitride semiconductor layer and the active layer,
wherein growing, on the template layer, a III nitride semiconductor region includes growing the n-type first III nitride semiconductor layer and the n-type second III nitride semiconductor layer using at least one of first to third conditions as follows:
the first condition in which a growth temperature of the n-type first III nitride semiconductor layer is greater than that of the n-type second III nitride semiconductor layer;
the second condition in which a growth rate of the n-type first III nitride semiconductor layer is greater than that of the n-type second III nitride semiconductor layer; and
the third condition in which an NH₃ partial pressure of the n-type first III nitride semiconductor layer is greater than that of the n-type second III nitride semiconductor layer.

12. The method according to claim 11, wherein a growth temperature of the n-type first III nitride semiconductor layer is 1100 degrees Celsius or more,
a growth temperature of the n-type second III nitride semiconductor layer is less than 1100 degrees Celsius,
a growth rate of the n-type first III nitride semiconductor layer is 400 nm/h or less,
a growth rate of the n-type second III nitride semiconductor layer is greater than 400 nm/h,
an NH₃ partial pressure of the n-type first III nitride semiconductor layer is not less than 10 kPa, and
an NH₃ partial pressure of the n-type second III nitride semiconductor layer is less than 10 kPa.

13. The method according to claim 11, wherein the n-type first III nitride semiconductor layer is an AlGaN layer having an Al molar fraction of 0.7 or more, and the n-type second III nitride semiconductor layer is an AlGaN layer having an Al molar fraction of 0.7 or more.

14. The method according to any one of claims 11 to 13, wherein a thickness of the n-type first III nitride semiconductor layer is larger than that of the n-type second III nitride semiconductor layer, and a first Al molar fraction of the n-type first III nitride semiconductor layer is larger than a second Al molar fraction of the n-type second III nitride semiconductor layer.

15. The method according to any one of claims 11 to 14, wherein the substrate includes at least one material of carbon, boron nitride (BN), aluminum oxide (sapphire), ceramics, silicon carbide, refractory metals, zirconia, tantalum carbide (TaC), or ScAlMgO₄.

16. The method according to any one of claims 11 to 15, wherein the substrate has a hexagonal crystalline structure and an off-angle of 0.5 degrees or less relative to c-face of the substrate.
